# EUROPEAN PATENT APPLICATION

(11) **EP 4 665 106 A1**
(43) Date of publication of application: **17.12.2025**
(21) Application number: 24181851.7
(22) Date of filing: 13.06.2024
(51) Int. Cl.: H10B 10/00, H01L 21/8238, H01L 23/528, H01L 27/06, H01L 29/06, H01L 29/775

(54) **A STATIC RANDOM ACCESS MEMORY DEVICE**

(71) Applicant: Imec VZW, 3001 Leuven (BE)
(72) Inventor: ABDI, Dawit Burusie, 3001 Leuven (BE); HELLINGS, Geert, 1500 Halle (BE); RYCKAERT, Julien, 1030 Schaerbeek (BE); WECKX, Pieter, 3380 Bunsbeek (BE)
(74) Representative: Lind Edlund Kenamets Intellectual Property AB

(57) **Abstract**

In an aspect there is provided an SRAM device comprising:
a plurality of rows of transistor structures extending in parallel in a first direction and spaced apart in a second direction transverse to the first direction, wherein the first direction corresponds to a channel direction of the transistor structures and wherein each row comprises bottom transistor structures of a bottom transistor tier and top transistor structures of a top transistor tier, wherein the bottom transistor structures and the top transistor structures are of complementary conductivity types;
a plurality of SRAM bit cells, each comprising a first and second half cell,
wherein the half cells of the plurality of bit cells are arranged in a plurality of cell rows, each cell row comprising a respective row of transistor structures,
wherein each first half cell comprises a first inverter, and a first pass gate coupled between the first inverter and a bit line, and each second half cell comprises a second inverter cross-coupled with the first inverter, and a second pass gate coupled between the second inverter and a bit line bar, and
wherein the first inverter comprises a first stacked transistor structure comprising a first bottom and first top transistor structure having a first shared gate, the second inverter comprises a second stacked transistor structure comprising a second bottom and second top transistor structure having a second shared gate, the first pass gate comprises a third bottom or top transistor structure, and the second pass gate comprises a fourth bottom or top transistor structure; and

a plurality of power rail structures extending in parallel in the first direction, wherein the power rail structures are interleaved with the rows of transistor structures such that a respective pair of neighboring first and second cell rows comprising a respective pair of neighboring first and second rows of transistor structures is arranged between each pair of consecutive power rail structures,
wherein each power rail structure comprises a bottom power rail and a top power rail stacked over the bottom power rail, and
wherein the bottom and top transistor structures of each inverter are respectively coupled to the bottom and top power rails of the neighboring power rail structure.

## Description

### TECHNICAL FIELD

The present invention generally relates to a static random access memory device.

### BACKGROUND

Static Random Access Memory (SRAM) is a widely used memory technology, for instance in embedded systems and modern computing devices. A common type of SRAM bit cell is the 6-transistor SRAM bit cell, comprising two pairs of transistors of complementary channel types (P-type and N-type) configured as two cross-coupled inverters, and first and second pass gates (or access transistors) coupling the inverters to a bit line and a bit line bar, respectively. SRAM bit-cells are typically designed to be as small as possible since SRAM occupies a significant portion of the system's real estate in modern computing devices. Hence, in line with the general strive in the industry to provide ever more area efficient circuit designs, there is considerable interest in realizing area efficient implementations of the 6-transistor SRAM bit cell.

### SUMMARY

The Complementary Field-Effect Transistor (CFET) is a stacked transistor structure comprising a bottom transistor structure and a top transistor structure stacked over the bottom transistor structure. The bottom and top transistor structures (or bottom and top devices) are of complementary channel types (e.g., an NMOS device stacked on top of a PMOS device, or vice versa). The CFET thus allows a reduced footprint compared to a traditional side-by-side arrangement of a complementary transistor pair. The CFET is hence an enabling technology for denser and more area-efficient circuits.

However, as realized by the inventors, an obstacle to realizing area-efficient implementations of SRAM bit cells utilizing CFETs is that conventional CFET-based circuit cell designs (in logic as well as SRAM) typically comprise a pair of power rails on either side of each row of CFETs for supplying power (VSS and VDD) to the bottom and top transistor tiers. The space between neighboring rows of CFETs hence needs to accommodate interconnects (e.g., vertical connects such as tall vias) both for connecting the bottom and top devices along the pair of rows of CFETs to the associated power rail, as well as for routing signals to and/or between the bottom and top transistor tiers. This may contribute to routing congestion between the rows and limit the possibility to scale the height of the circuit cells (as measured across the row direction).

In view of the above, it is an object of the present invention to provide an SRAM device having a bit cell design utilizing stacked transistor structures but avoiding or mitigating the above-mentioned issues. Further and alternative objectives may be understood from the following.

According to an aspect of the present invention, there is provided an SRAM device comprising:
a plurality of rows of transistor structures extending in parallel in a first direction and spaced apart in a second direction transverse to the first direction, wherein the first direction corresponds to a channel direction of the transistor structures and wherein each row comprises bottom transistor structures of a bottom transistor tier and top transistor structures of a top transistor tier, wherein the bottom transistor structures and the top transistor structures are of complementary conductivity types;
a plurality of SRAM bit cells, each comprising a first and second half cell,
   wherein the half cells of the plurality of bit cells are arranged in a plurality of cell rows, each cell row comprising a respective row of transistor structures,
   wherein each first half cell comprises a first inverter, and a first pass gate coupled between the first inverter and a bit line, and each second half cell comprises a second inverter cross-coupled with the first inverter, and a second pass gate coupled between the second inverter and a bit line bar, and
   wherein the first inverter comprises a first stacked transistor structure comprising a first bottom and first top transistor structure having a first shared gate, the second inverter comprises a second stacked transistor structure comprising a second bottom and second top transistor structure having a second shared gate, the first pass gate comprises a third bottom or top transistor structure, and the second pass gate comprises a fourth bottom or top transistor structure; and
a plurality of power rail structures extending in parallel in the first direction, wherein the power rail structures are interleaved with the rows of transistor structures such that a respective pair of neighboring first and second cell rows comprising a respective pair of neighboring first and second rows of transistor structures is arranged between each pair of consecutive power rail structures,
   wherein each power rail structure comprises a bottom power rail and a top power rail stacked over the bottom power rail, and
wherein the bottom and top transistor structures of each inverter are respectively coupled to the bottom and top power rails of the neighboring power rail structure.

The bottom and top transistor tiers of the rows of transistor structures (in the following interchangeably "transistor rows") enables a CFET based implementation of the inverters of the bit cells. That is, the first and second stacked transistor structures are each CFETs configured as inverters. Each inverter may hence be realized with a reduced footprint compared to a side-by-side arrangement of a complementary transistor pair.

Contrary to conventional CFET-based circuit implementations, the present SRAM device comprises power rail structures provided between only every other row of transistor structures. Further, each power rail structure comprises a bottom power rail and a top power rail stacked over the bottom power rail. The bottom and top transistor structures of a first or second inverter may thus be supplied with power from a single side, as opposed to two sides as in conventional implementations.

This configuration of a pair consecutive power rails surrounding a pair of first and second transistor rows (and cell rows) may in the following be referred to as a "double-row configuration". It is to be noted that the double-row configuration implies that there is no power rail track provided between the two transistor rows of the double-row configuration and further that each of the transistor rows comprises stacked transistor structures in the form of CFETs.

Accordingly, the space between the two transistor rows which in conventional implementations would be allocated to a power rail track is here hence replaced by a "spacer track" which is absent of a power rail structure and hence may be used for other purposes than power routing.

The double-row configuration, combined with the stacked structure of the surrounding pair of power rail structures thus obviates the need for accommodating both vertical interconnects for power and for signal routing between the two transistor rows. Routing congestion within the space between the two transistor rows may hence be reduced, which in turn may facilitate scaled cell height and low track height implementations of the SRAM bit cells.

As will become apparent from the following, the spacer track may be used to accommodate interconnect segments dedicated for interconnecting bottom and top source/drain (S/D) contacts of the bottom and top transistor tiers. The spacer track may also be absent of conductive structures and merely serve as an electrical and physical separation between the respective first and second transistor rows. In either case, a competition between power routing and signal routing along the spacer track may be eliminated. It is to be noted that the presence of a spacer track does not preclude connections across the spacer track using frontside interconnect layers arranged over the top transistor tier, or using backside interconnect layers below the bottom transistor tier.

In some embodiments, the bottom power rails are arranged in the bottom transistor tier or in a backside interconnect layer, and/or wherein the top power rails are arranged in the top transistor tier.

The bottom and top power rails will hence not contribute to routing congestion in interconnect layers of a frontside interconnect structure over the top transistor tier. Rather, the top transistor structure of the inverters along any given transistor row and cell row may be simply coupled with a neighboring top power rail by merely a lateral extension of a top S/D contact portion of the top transistor structure (along the second direction) to an edge of the cell. In implementations wherein the bottom power rails are arranged in the bottom transistor tier, a corresponding advantage applies to the power distribution to the bottom transistor structures of the inverters.

A further and more subtle advantage of the present SRAM device is that the double row configuration also may be used to implement standard cells (e.g., logic cells and I/O cells) with a cell and track height matching those of the cell rows of the SRAM device. (As may be better understood from the following, the cell or track height of a "cell row" may depending on implementation either correspond to height of the SRAM bit cells or the height of the half cells of the SRAM bit cells.) This allows the SRAM bit cells and standard cells to have the same template, thereby opening design possibilities to enhance SRAM array performance through the integration of circuits between arrays with minimal area overhead. In terms of integration, this further provides the benefit of enabling the SRAM bit cells to be fabricated with a similar number of process modules as those used in the logic circuits.

Thus, in some embodiments, the SRAM device further comprises peripheral circuitry comprising a plurality of rows of logic circuit cells, each comprising:
a pair of (consecutive) power rail structures extending in parallel in the first direction;
at least a first stacked transistor structure (first CFET) of a first row of transistor structures, and at least a second stacked transistor structure (second CFET) of a second row of transistor structures, wherein the first and second rows of transistor structures extend in parallel in the first direction and are arranged between the pair of power rail structures; and
a shared signal routing structure arranged between the first and second rows of transistor structures and electrically coupled to: a bottom transistor structure of the first stacked transistor structure, a top transistor structure of the first stacked transistor structure, a bottom transistor structure of the second stacked transistor structure, and/or a top transistor structure of the second stacked transistor structure.

The shared signal routing structure may comprise a row of interconnect segments, each coupled to one or more of the transistor structures. The shared signal routing structure may in particular be coupled to respective source/drain regions of the respective transistor structures.

While each of the power rail structures associated with the SRAM bit cells comprises a bottom power rail and a top power rail, the power rail structures associated with the peripheral circuitry need not necessarily have a stacked design. For instance, in some circuit cell implementations, it may suffice to supply a pull-down voltage (VSS) to the first CFET(s) of the first transistor row and a pull-up voltage (VDD) to the second CFET(s) of the second transistor row. Still, owing to the double-row configuration, the pairs of power rail structures associated with the peripheral circuitry may be arranged with a same pitch as the power rail structures associated with the SRAM bit cells. Hence, the logic circuit cells and SRAM bit cells may be implemented with matching cell and track heights.

Since a pass gate may be realized by a single transistor structure, the first and second pass gates of the bit cells may be realized by a respective bottom transistor structure in the bottom transistor tier or a top transistor structure in the top transistor tier.

In some embodiments, each pass gate of each bit cell is formed by a respective bottom transistor structure comprised in a respective stacked transistor structure further comprising a top transistor structure configured as a dummy transistor structure. Hence, also the pass gates may be realized without requiring an excessive number of additional process modules over those needed to realize the inverters (e.g., the CFETs implementing the inverters).

By "dummy transistor structure" (or "dummy device") is herein meant a transistor structure not being functionally or electrically connected to the SRAM device, and/or lacking at least one of a channel structure, a functional gate, or a S/D region.

As discussed above, the double-row based configuration of the SRAM bit cells enables scaled cell height and low track height implementations of the SRAM bit cells. In some embodiments, the SRAM device further comprises a bottom frontside interconnect layer of a frontside interconnect structure arranged on top of the top transistor tier and comprising a plurality of bottom frontside routing tracks extending in parallel in the first direction, and wherein a pitch of the power rail structures corresponds to 7 times a pitch of the bottom routing tracks.

The first and second cell rows between each pair of consecutive power rail structures may hence be implemented with a combined track height of 7 tracks (7T) of the routing tracks of the bottom frontside interconnect layer. This corresponds to a track height of 3.5 tracks (3.5T) for each cell row or half cell. By way of comparison, this is 0.5 tracks less than the track height of a conventional CFET-based minimum track height logic circuit cell implementation comprising power rails on either side of each CFET row.

In some embodiments, each half cell has a width along the first direction corresponding to 2 times a contacted poly pitch, CPP, of the transistor structures of the half cells.

Thus each half cell of each cell row may implemented with a cell width of 2 times the CPP (2CPP) of the transistor structures. This implies that the first inverters and pass gate, and the second inverters and pass gate, respectively, are provided along two consecutive gate tracks. Where a 2CPP cell width is combined with a 3.5T cell row / half cell height, the bit cells may accordingly have an area or footprint of 2CPP*7T (where the first and second half cells of each respective bit cell are arranged along different cell rows) or 4CPP*3.5T (where the first and second half cells of each respective bit cell are arranged along a same cell row).

Arranging the first inverter and the first pass gate along a same transistor row and the second inverter and the second pass gate along a same transistor row enables the respective inverter-to-pass gate connections to be realized without utilizing routing resources above the top transistor tier. In particular, the respective connections may be provided by a respective shared S/D contact arranged between the first and third transistor structures, and between the second and fourth transistor structures.

Thus, in some embodiments, a first source/drain, S/D, region of the third bottom or top transistor structure of the first pass gate and first bottom and top S/D regions of the first stacked transistor structure of the first inverter of each first half cell are interconnected by a first shared S/D contact structure arranged between the first and third transistor structures of the respective half cell; and a first S/D region of the fourth bottom or top transistor structure of the second pass gate and first bottom and top S/D regions of the second stacked transistor structure of the second inverter of each second half cell are interconnected by a second shared S/D contact structure arranged between the second and fourth transistor structures of the respective half cell.

This configuration may advantageously be combined with 2CPP half cells.

In some embodiments, the SRAM device further comprises a plurality of rows of interconnect segments extending in parallel in the first direction, wherein each row of interconnect segments extends along a shared boundary between a respective pair of neighboring first and second cell rows,
wherein each shared S/D contact structure comprises a bottom S/D contact portion, a top S/D contact portion, and a respective one of the interconnect segments, and
wherein the bottom and top S/D contact portions are vertically spaced apart from each other, and wherein the interconnect segment is arranged laterally adjacent to and in abutment with the bottom and top S/D contact portions to interconnect the same.

The bottom and top S/D contact portions of each shared S/D contact structure may thus be interconnected by a respective interconnect segment arranged laterally adjacent the transistor row, on the boundary between the cell rows. This obviates the need for providing a "S/D contact merge layer" vertically between the bottom and top S/D contact portions, which may introduce additional complexities during fabrication, in particular at aggressively scaled cell heights.

The bottom S/D contact portion may be arranged in the bottom transistor tier and abut a first bottom S/D region of the associated bottom transistor structure. The top S/D contact portion may be arranged in the top transistor tier and abut a first top S/D region of the associated top transistor structure. The bottom and top S/D contact portions may be vertically spaced apart, e.g., by an insulating layer portion.

Each interconnect segment may extend between the bottom and top transistor tiers to bridge the vertical separation of the bottom and top S/D contact portions and interconnect the same.

A further benefit is that the stacked transistor structures (i.e., CFETs) of the SRAM device, either in the SRAM (sub-)array or in an SRAM periphery, may be fabricated using a sequential process, wherein the bottom and top S/D contact portions may be formed as separate, vertically spaced contacts. Then the interconnect segments of the shared S/D contact structures may be provided adjacent the bottom and top S/D contact portions which are to be interconnected. This further contributes to realizing the SRAM cells by introducing only a small number of additional process steps over those for forming logic cells based on CFETs.

In some embodiments, in each pair of neighboring first and second cell rows, the second cell row is displaced relative the first cell row along the first direction by a distance corresponding to one CPP such that the shared S/D contact structures associated with the half cells of the first cell row are displaced relative the shared S/D contact structures associated with the half cells of the second cell row by a corresponding distance,
wherein every first interconnect segment of each respective row of interconnect segments is comprised in a respective shared S/D contact structure associated with a half cell of the first cell row and every second interconnect segment of the row of interconnect segments is comprised in a respective shared S/D contact structure associated with a half cell of the second cell row.

Thereby, the half cells of the first and second cell rows (or equivalently the transistor structures of the first and second transistor rows) may be offset with respect to each other by one CPP (or equivalently one gate track) such that shared S/D contact structures of the first and second cell rows do not align. Each interconnect segment may thus be configured to selectively interconnect the bottom and top S/D contact portions of either the first or second cell row, without risking shorting to a shared S/D contact structure of the other cell row.

As may be appreciated, each shared S/D contact structure is electrically coupled to or forms part of the respective storage node of its associated half cell and should hence not be in galvanic contact with a shared S/D contact structure of another half cell.

This offset or displacement between the cell rows further enables the interconnect segments of each row to be arranged with a regular pitch corresponding to the CPP.

In some embodiments, the first and second half cell of each respective bit cell are comprised in a same cell row such that each first cell row comprises the first and second half cells of a respective first subset of bit cells and each second cell row comprises the first and second half cells of a respective second subset of bit cells.

The half cells of each respective bit cell may thus be arranged along a same cell row. Correspondingly, the first through fourth transistor structures of each respective bit cell may be comprised in a same transistor row.

The first and second stacked transistor structures of each respective bit cell may be arranged between the third and fourth transistor (bottom or top) structures of the bit cell. Hence, bit line contacts and/or bit line bar contacts may be arranged at the edges of the cells.

The SRAM device may further comprise, a set of first bit lines and bit line bars and a set of second bit lines and bit line bars arranged in a backside interconnect layer in a set of backside routing tracks extending in parallel in the first direction, wherein each first bit line and bit line bar are arranged below a respective first cell row and coupled to the first and second pass gates thereof, and wherein each second bit line and bit line bar are arranged below a respective second cell row and coupled to the first and second pass gates thereof.

Since the first and second half cells are arranged along a same cell row, and the first and second pass gates accordingly are arranged along a same transistor row, a respective instance of a bit line and a bit line bar needs to be provided along each cell row. By arranging the first and second bit lines and bit line bars in the backside interconnect layer, routing congestion in the frontside interconnect structure may be alleviated.

The first and second bit lines and bit line bars may be coupled to the respective pass gates by backside contacts arranged between the backside interconnect layer and the bottom transistor tier.

The SRAM device may further comprise, a set of cross-couple interconnects, wherein each cross-couple interconnect is configured to couple a storage node of a half cell of a respective bit cell to the shared gate of the inverter of the other half cell of the bit cell, and wherein each cross-couple interconnect comprises a cross-couple portion arranged in a bottom frontside interconnect layer in a routing track of a set of bottom frontside routing tracks extending in parallel in the first direction.

Since the first and second half cells are arranged along a same cell row, the cross coupling of the first and second inverters may be realized along a single horizontal routing direction. Hence, the horizontal routing resources of the routing tracks of the bottom (bottom-most) frontside interconnect layer suffice to provide the cross-couplings, without relying on routing resources of higher interconnect layers.

Each cross-couple interconnect may further comprise a respective pair of vias of a bottom (bottom-most) via layer arranged between the top transistor tier and the bottom frontside interconnect layer. The pair of vias may electrically couple the respective cross-couple portion to the associated storage node (e.g., by abutting the shared S/D contact structure) of the half cell and to the shared gate of the inverter of the other half cell.

The SRAM device may further comprise, a set of word lines arranged in an upper frontside interconnect layer in a set of upper frontside routing tracks extending in parallel in the second direction, wherein each word line is arranged over a respective column of the bit cells, and wherein the pass gates of each column of bit cells is coupled to the respective word line arranged over the column of the bit cells.

Each column of bit cells, as seen along the second direction, may thus be coupled to a respective word line extending across the cell rows. The word lines may be coupled to the respective pass gates by one or more interconnect layers and via layers between the upper frontside interconnect layer and the gates of the pass gates.

In view of the above, each of the bit line / bit line bar connections, the cross-coupling and the word line connections may be realized using Manhattan-style routing, without use of non-Manhattan patterns (such as diagonally extending or curvilinear metal lines) or multi-level vias, each of which may introduce additional complexities during floor planning, design rule checking and fabrication.

In some embodiments, the first and second half cell of each respective bit cell are comprised in different neighboring cell rows.

The first and second half cells each respective bit cell may thus be distributed between different neighboring cell rows. Correspondingly, the first stacked transistor structure and the third (bottom or top) transistor structure of the bit cell may be comprised in a first transistor row, and the second stacked transistor structure and the fourth (bottom or top) transistor structure of the bit cell may be comprised in a second transistor row.

The SRAM device may further comprise, a set of bit lines and bit line bars arranged in a backside interconnect layer in a set of backside routing tracks extending in parallel in the first direction, wherein each bit line is arranged below a respective first cell row and coupled to the first pass gates thereof, and wherein each bit line bar is arranged below a respective second cell row and coupled to the second pass gates thereof.

By arranging the bit lines and bit line bars in the backside interconnect layer, routing congestion in the frontside interconnect structure due to the routing tracks used by the bit lines and bit line bars may be alleviated.

Further, since the first and second half cells are arranged along different cell rows, and the first and second pass gates accordingly are arranged along different transistor rows, only one of a bit line or a bit line bar needs to be provided along each cell row. In particular, the bit line may be arranged in a backside routing track below (i.e., to overlap) the transistor row comprising the first pass gates. Correspondingly, the bit line bar may be arranged in a backside routing track below (i.e., to overlap) the transistor row comprising the second pass gates. The bit lines and bit line bars may thus each be coupled to the respective pass gates by a bit line or bit line bar contact configured as a backside contact arranged below the S/D region of the respective pass gate.

The SRAM device may further comprise, a set of cross-couple interconnects, wherein each cross-couple interconnect is configured to couple a storage node of a half cell of a respective bit cell to the shared gate of the inverter of the other half cell of the bit cell, and wherein each cross-couple interconnect comprises a first and second cross-couple portion arranged in a bottom frontside interconnect layer in respective routing tracks of a set of bottom frontside routing tracks extending in parallel in the first direction, and a third cross-couple portion arranged in an intermediate frontside interconnect layer in a routing track of a set of intermediate frontside routing tracks extending in parallel in the second direction.

The first and second inverters may thus be cross-coupled between their respective transistor rows by cross-couple interconnects using horizontal routing resources of the bottom (bottom-most) frontside interconnect layer (providing routing along the first direction) and the intermediate (e.g., second bottom-most) frontside interconnect layer (providing routing along the second direction).

Each cross-couple interconnect may further comprise a respective pair of bottom vias of a bottom (bottom-most) via layer arranged between the top transistor tier and the bottom frontside interconnect layer. The pair of bottom vias may electrically couple the respective first cross-couple portions to the associated storage node (e.g., by abutting the shared S/D contact structure) of the half cell and to the shared gate of the inverter of the other half cell.

Each cross-couple interconnect may further comprise a respective pair of intermediate vias of an intermediate (e.g., second bottom-most) via layer arranged between the bottom frontside interconnect layer and intermediate frontside interconnect layer. The pair of intermediate vias may electrically couple the first and second cross-couple portions, respectively, to the third cross-couple portion.

The first, second and third cross-couple interconnects may each be formed as lines or line segments.

The SRAM device may further comprise a set of word lines arranged in an upper frontside interconnect layer in a set of upper frontside routing tracks extending in parallel in the second direction, wherein each word line is arranged over a respective column of the bit cells, and wherein the pass gates of each column of bit cells are coupled to the respective word line arranged over the column of the bit cells.

Each column of bit cells, as seen along the second direction, may thus be coupled to a respective word line extending across the cell rows. The word lines may be coupled to the respective pass gates by one or more interconnect layers and via layers between the upper frontside interconnect layer and the gates of the pass gates.

In view of the above, each of the bit line / bit line bar connections, the cross-coupling and the word line connections may be realized using Manhattan-style routing, without use of non-Manhattan patterns (such as diagonally extending or curvilinear metal lines) or multi-level vias, each of which may introduce additional complexities during floor planning, design rule checking and fabrication.

In some embodiments, the first cell row of each respective pair of neighboring first and second cell rows comprises the first half cells of a respective subset of bit cells and the second cell row comprises the second half cells of the subset of bit cells.

Thus, the first and second half cells of each respective bit cell may be arranged between a same pair of consecutive power rail structures. By distributing the first and second half-cells between two cell rows, only one of a bit line and a bit line bar needs to be arranged along each row. This reduces the number of routing tracks needed to accommodate the bit lines between each pair of power rail structures. This in turn provides space for an additional shielding metal line in a routing track between the bit line and bit line bar, which may reduce bit line coupling.

In some embodiments, the first cell row of each respective pair of neighboring first and second cell rows comprises the first half cells of a respective first subset of bit cells and the second cell row comprises the second half cells of a respective second subset of bit cells.

Thus, the first and second half cells of each respective bit cell may be arranged on opposite sides of a power rail structure. In other words, neighboring first and second half cells between a respective pair of power rail structures may belong to different bit cells.

This may enable a more symmetrical distribution of transistors within each respective bit cell, as the first and second half cells of each bit cell may be aligned, i.e., not displaced with respect to each other along the first direction (i.e., such that the inverters and pass gates of the respective half cells are arranged along a same pair of gate tracks).

The shared gate of the inverter of a half cell of each respective bit cell and a gate of the pass gate of the other half cell of the bit cell may be arranged along a same gate track. That is, the first pass gate may be arranged along a same gate track as the second inverter and the second pass gate may be arranged along a same gate track as the first inverter.

In addition to contributing to a symmetrical distribution of transistors within the bit cells, this may facilitate the cross-coupling, since each cross-couple interconnect only needs to bridge a distance of one half CPP (0.5CPP), which corresponds to the separation between the respective shared gate and storage node along the first direction.

Where the shared gate of the inverter and the gate of the pass gate are arranged along a same gate track, the gate of the pass gate may be coupled to its associated word line by a multi-level via extending through (i.e., electrically bypassing) the intermediate frontside interconnect layer.

As discussed above, the gate of a pass gate of a respective half cell may be coupled to an associated word line arranged in an upper frontside interconnect layer. The coupling between the gate and the word line may be provided by, among others, an intermediate interconnect (e.g., a line segment) arranged in an intermediate routing track of an intermediate frontside interconnect layer (e.g., second bottom-most frontside interconnect layer). This intermediate routing track may be shared with the third cross-couple portion of the cross-couple interconnect associated with the shared gate of the inverter of the other half cell. This may result in a tight tip-to-tip separation between the intermediate interconnect and the third cross-couple portion along the intermediate routing track. Providing a multi-level via for the pass gate to word line connection obviates the need for the intermediate interconnect (e.g., line segment) for the word line connection along the intermediate routing track and may hence avoid a tight tip-to-tip separation along the intermediate routing track.

Embodiments wherein the spacer tracks do not comprise rows of interconnect segments will now be discussed.

In some embodiments, each first and second shared S/D contact structure comprises a S/D contact merge layer arranged between and configured to interconnect a bottom S/D contact portion and a top S/D contact portion of the shared S/D contact structure.

Each spacer track between a pair of cell rows may hence be used to merely provide physical and electrical separation between transistor structures of the cell rows. The interconnection of the bottom and top S/D contact portions of each shared S/D contact structures may instead be provided by an intermediate S/D merge contact layer.

In some embodiments, each spacer track comprises an insulating wall structure extending continuously along the spacer track (e.g., along a shared boundary between a respective pair of neighboring first and second cell rows) to electrically and physically separate the associated first and second rows of transistor structures within the top and bottom transistor tiers. In other words, the insulating wall structure may thus be configured to partition each of the bottom transistor tier and the top transistor tier between the neighboring cell rows.

In some embodiments, the first and second cell rows are aligned such that each shared S/D contact structure associated with a half cell of the first cell row is arranged directly opposite a respective shared S/D contact structure associated with a half cell of the second cell row, as seen along the second direction.

The cell rows may hence be arranged in a non-staggered fashion, which may contribute to an overall more regular layout of the bit cells. The aligned configuration is at least in part facilitated by the absence of conductive structures in the spacer tracks, enabling an increased process margin when forming the S/D contact merge layers for opposite shared S/D contact structures.

In some embodiments, the first and second half cell of each respective bit cell are comprised in a same cell row.

The half cells of each respective bit cell may thus be arranged along a same cell row. Correspondingly, the first through fourth transistor structures of each respective bit cell may be comprised in a same transistor row.

The first and second stacked transistor structures of each respective bit cell may be arranged between the third and fourth transistor (bottom or top) structures of the bit cell. Hence, bit line contacts and/or bit line bar contacts may be shared between first and second pass gates, respectively, of neighboring cells along a respective cell row.

The SRAM device may further comprise, a set of cross-couple interconnects, wherein each cross-couple interconnect is configured to couple a storage node of a half cell of a respective bit cell to the shared gate of the inverter of the other half cell of the bit cell, and wherein each cross-couple interconnect comprises a cross-couple portion arranged in a bottom frontside interconnect layer in a routing track of a set of bottom frontside routing tracks extending in parallel in the first direction.

Since the first and second half cells are arranged along a same cell row, the cross-coupling of the first and second inverters may be realized along a single horizontal routing direction. Hence, the horizontal routing resources of the routing tracks of the bottom (bottom-most) frontside interconnect layer suffice to provide the cross-couplings, without relying on routing resources of higher interconnect layers.

Each cross-couple interconnect may further comprise a respective pair of vias of a bottom (bottom-most) via layer arranged between the top transistor tier and the bottom frontside interconnect layer. The pair of vias may electrically couple the respective cross-couple portion to the associated storage node (e.g., by abutting the shared S/D contact structure) of the half cell and to the shared gate of the inverter of the other half cell.

The SRAM device may further comprise, a set of word lines arranged in an upper frontside interconnect layer in a set of upper frontside routing tracks extending in parallel in the second direction, wherein each word line is arranged over a respective column of the bit cells, and wherein the pass gates of each column of bit cells is coupled to the respective word line arranged over the column of the bit cells.

Each column of bit cells, as seen along the second direction, may thus be coupled to a respective word line extending across the cell rows. The word lines may be coupled to the respective pass gates by one or more interconnect layers and via layers intermediate the upper frontside interconnect layer and the gates of the pass gates.

The SRAM device may further comprise, a set of first bit lines and bit line bars and a set of second bit lines and bit line bars arranged in a further interconnect layer in a set of further routing tracks extending in parallel in the first direction, wherein each first bit line and bit line bar are arranged along a respective first cell row and coupled to the first and second pass gates thereof, and wherein each second bit line and bit line bar are arranged along a respective second cell row and coupled to the first and second pass gates thereof.

Since the first and second half cells are arranged along a same cell row, and the first and second pass gates accordingly are arranged along a same transistor row, a respective instance of a bit line and a bit line bar needs to be provided along each cell row.

The further interconnect layer may be a backside interconnect layer. By arranging the first and second bit lines and bit line bars in the backside interconnect layer, routing congestion in the frontside interconnect structure may be alleviated. However, the further interconnect layer may also be an intermediate frontside interconnect layer arranged between the bottom and upper frontside interconnect layers.

In some embodiments, the first and second half cell of each respective bit cell are comprised in different neighboring cell rows such that each first half cell is comprised in a first cell row and each second half cell is comprised in a second cell row.

The first and second half cells each respective bit cell may thus be distributed between different neighboring cell rows. More specifically, the first and second half cells of each respective bit cell may be arranged between a same pair of consecutive power rail structures. This applies correspondingly to the first through fourth transistor structures of each bit cell. That is, the first stacked transistor structure and the third (bottom or top) transistor structure of the bit cell may be comprised in a first transistor row between the pair of power rail structures, and the second stacked transistor structure and the fourth (bottom or top) transistor structure of the bit cell may be comprised in a second transistor row between the pair of power rail structures.

The SRAM device may further comprise, a set of bit lines and bit line bars arranged in a backside interconnect layer in a set of backside routing tracks extending in parallel in the first direction, wherein each bit line is arranged below a respective first cell row and coupled to the first pass gates thereof, and wherein each bit line bar is arranged below a respective second cell row and coupled to the second pass gates thereof.

By arranging the bit lines and bit line bars in the backside interconnect layer, routing congestion in the frontside interconnect structure due to the routing tracks used by the bit lines and bit line bars may be alleviated.

Further, since the first and second half cells are arranged along different cell rows, and the first and second pass gates accordingly are arranged along different transistor rows, only one of a bit line or a bit line bar needs to be provided along each cell row. In particular, the bit line may be arranged in a backside routing track below (i.e., to overlap) the transistor row comprising the first pass gates. Correspondingly, the bit line bar may be arranged in a backside routing track below (i.e., to overlap) the transistor row comprising the second pass gates. The bit lines and bit line bars may thus each be coupled to the respective pass gates by a bit line or bit line bar contact configured as a backside contact arranged below the S/D region of the respective pass gate. Further, since only one of a bit line and a bit line bar needs to be arranged along each row, this in turn provides space for an additional shielding metal line in a routing track between the bit line and bit line bar, which may reduce bit line coupling.

The SRAM device may further comprise, a set of cross-couple interconnects, wherein each cross-couple interconnect is configured to couple a storage node of a half cell of a respective bit cell to the shared gate of the inverter of the other half cell of the bit cell, and wherein each cross-couple interconnect comprises a first and second cross-couple portion arranged in a bottom frontside interconnect layer in respective routing tracks of a set of bottom frontside routing tracks extending in parallel in the first direction, and a third cross-couple portion arranged in an intermediate frontside interconnect layer in a routing track of set of intermediate frontside routing tracks extending in parallel in the second direction.

The first and second inverters may thus be cross-coupled between their respective transistor rows by cross-couple interconnects using horizontal routing resources of the bottom (bottom-most) frontside interconnect layer (providing routing along the first direction) and the intermediate (e.g., second bottom-most) frontside interconnect layer (providing routing along the second direction).

Each cross-couple interconnect may further comprise a respective pair of bottom vias of a bottom (bottom-most) via layer arranged between the top transistor tier and the bottom frontside interconnect layer. The pair of bottom vias may electrically couple the respective first cross-couple portions to the associated storage node (e.g., by abutting the shared S/D contact structure) of the half cell and to the shared gate of the inverter of the other half cell.

Each cross-couple interconnect may further comprise a respective pair of intermediate vias of an intermediate (e.g., second bottom-most) via layer arranged between the bottom frontside interconnect layer and intermediate frontside interconnect layer. The pair of intermediate vias may electrically couple the first and second cross-couple portions, respectively, to the third cross-couple portion.

The first, second and third cross-couple interconnects may each be formed as lines or line segments.

The SRAM device may further comprise a set of word lines arranged in an upper frontside interconnect layer in a set of upper frontside routing tracks extending in parallel in the second direction, wherein each word line is arranged over a respective column of the bit cells, and wherein the pass gates of each column of bit cells is coupled to the respective word line arranged over the column of the bit cells

Each column of bit cells, as seen along the second direction, may thus be coupled to a respective word line extending across the cell rows. The word lines may be coupled to the respective pass gates by one or more interconnect layers and via layers between the upper frontside interconnect layer and the gates of the pass gates.

In view of the above, each of the bit line / bit line bar connections, the cross-coupling and the word line connections may be realized using Manhattan-style routing, without use of non-Manhattan patterns (such as diagonally extending or curvilinear metal lines) or multi-level vias, each of which may introduce additional complexities during floor planning, design rule checking and fabrication.

The shared gate of the inverter of a half cell of each respective bit cell and a gate of the pass gate of the other half cell of the bit cell may be arranged along a same gate track. That is, the first pass gate may be arranged along a same gate track as the second inverter and the second pass gate may be arranged along a same gate track as the first inverter.

In addition to contributing to a symmetrical distribution of transistors within the bit cells, this may facilitate the cross coupling, since each cross-couple interconnect only needs to bridge a distance of one half CPP (0.5CPP), which corresponds to the separation between the respective shared gate and storage node along the first direction.

Where the shared gate of the inverter and the gate of the pass gate are arranged along a same gate track, the gate of the pass gate may be coupled to its associated word line by a multi-level via extending through (i.e., electrically bypassing) the intermediate frontside interconnect layer.

As discussed above, the gate of a pass gate of a respective half cell may be coupled to an associated word line arranged in an upper frontside interconnect layer. The coupling between the gate and the word line may be provided by, among others, an intermediate interconnect (e.g., a line segment) arranged in an intermediate routing track of an intermediate frontside interconnect layer (e.g., second bottom-most frontside interconnect layer). This intermediate routing track may be shared with the third cross-couple portion of the cross-couple interconnect associated with the shared gate of the inverter of the other half cell. This may result in a tight tip-to-tip separation between the intermediate interconnect and the third cross-couple portion along the intermediate routing track. Providing a multi-level via for the pass gate to word line connection obviates the need for the intermediate interconnect (e.g., line segment) for the word line connection along the intermediate routing track and may hence avoid a tight tip-to-tip separation along the intermediate routing track.

In embodiments where the first and second half cells of each bit cell are comprised in different cell rows such that each first cell row comprises (only) first half cells and each second cell row comprises (only) second half cells, the half cells along each respective cell row may have alternating layouts.

More specifically:
in each first half cell of a respective first cell row, the order of the first pass gate and the first inverter, as seen along the first direction, may be flipped relative a neighboring first half cell of the first cell row, and
in each second half cell of a respective second cell row, the order of the second pass gate and the second inverter, as seen along the first direction, may be flipped relative to a neighboring second half cell of the second cell row.

Thereby, bit line contacts (when referring to a first cell row) or bit line bar contacts (when referring to a second cell row) for the pass gates may be shared between neighboring half cells of the respective cell row. Likewise, pull-up and pull-down contacts for the inverters may be shared between neighboring half cells of the respective cell row.

### BRIEF DESCRIPTION OF THE DRAWINGS

This and other aspects of the present invention will now be described in more detail, with reference to the appended drawings.
Fig. 1 is a circuit diagram of a conventional 6-transistor SRAM bit cell.
Fig. 2 schematically shows an example of two transistor rows in a double-row configuration.
Fig. 3 schematically shows a further example of two transistor rows in a double-row configuration.
Fig. 4 schematically shows a further example of two transistor rows in a double-row configuration.
Fig. 5 schematically shows a further example of two transistor rows in a double-row configuration.
Fig. 6a-d schematically shows a first example implementation of an SRAM device.
Fig. 7a-d schematically shows a second example implementation of an SRAM device.
Fig. 8a-d schematically shows a third example implementation of an SRAM device.
Fig. 9a-c schematically shows a fourth example implementation of an SRAM device.
Fig. 10a-c schematically shows a fifth example implementation of an SRAM device.
Fig. 11 schematically shows an example of a stacked transistor structure configured as a pass gate device.
Fig. 12 schematically shows a further example of a stacked transistor structure configured as a pass gate device.
Fig. 13 schematically shows a further example of a stacked transistor structure configured as a pass gate device.
Fig. 14 schematically shows an SRAM device comprising an array of bit cells and peripheral circuitry.

### DETAILED DESCRIPTION

In the following, a detailed description of example implementations of SRAM devices based on the so-called double-row configuration will be provided with reference to the drawings. The drawings are only schematic and the relative dimensions of illustrated elements, such as layers or other structures, may be exaggerated and not drawn to scale. Rather the dimensions may be adapted for illustrational clarity and to facilitate understanding. When present in the figures, the indicated axes X, Y and Z point in a first horizontal direction, a second horizontal direction, and a vertical direction, respectively. As is apparent from the figures, the X direction corresponds to a width dimension of the bit cells and a row direction of the plurality (array) of bit cells. The Y direction corresponds to a height dimension of the bit cells and a column direction of the plurality (array) of bit cells.

By the term "horizontal" is herein meant a direction parallel to a substrate of the SRAM device, i.e. parallel to a main surface (e.g., a frontside) of the substrate. The term "lateral" refers to a horizontal direction.

By the term "vertical" is herein meant a direction normal or transverse to the horizontal XY-plane, or equivalently, a direction normal or transverse to the substrate. Accordingly, terms indicating relative vertical arrangement of elements, such as "top", "upper", "bottom", "lower" and the like, are to be understood in relation to the vertical direction.

It is to be noted that when an element (e.g. an interconnect, a layer or other structure) is referred to as being "on" another element, it can be directly on the other element or on one or more intermediate elements on the other element. Conversely, when an element is referred to as being "directly on" another element, there is no intermediate element and the element is thus abutting (i.e., physically contacting) the other element.

It is further to be noted that terms such as "first" and "second" etc. with reference to elements (e.g. layers or other structures) may be used herein as labels to facilitate distinguishing between different elements, and need not necessarily imply that such elements are arranged or performed in that particular order, unless stated otherwise.

By the term "CFET" is herein meant a device, more specifically a stacked transistor structure, comprising a bottom transistor structure of a first conductivity type and a top transistor structure of a second conductive type opposite the first conductivity type stacked on top of the bottom transistor structure, e.g. an NMOS top device stacked on top of a PMOS bottom device, or vice versa. For conciseness, the bottom transistor structure and the top transistor structure may interchangeably be referred to as a bottom device and a top device, respectively. The bottom device is comprised in a bottom transistor tier of the SRAM device and the top device is comprised in a top transistor tier of the SRAM device.

By the term "frontside interconnect structure" is herein meant an interconnect structure (e.g., typically a back-end-of-line interconnect structure) comprising a vertical stack of interconnect and via layers arranged on a frontside of the SRAM device, over the top transistor tier (e.g., on a frontside of a substrate of the SRAM device).

By the term "backside interconnect structure" is herein meant an interconnect structure comprising one or more interconnect layers and one or more via layers arranged on a backside of the SRAM device, below the bottom transistor tier (e.g., on a backside of a substrate of the SRAM device).

By the term "interconnect layer" (frontside or backside) is herein meant a layer of horizontally (along the X and/or Y directions) routed interconnects, e.g., conductive traces, lines and/or contacts. An interconnect layer may also be referred to as a metal line layer, a metal routing layer or a metallization layer.

By the term "via layer" is herein meant a layer of vertically (along the Z direction) routed interconnects in the form of vias, providing vertical routing of signals between different interconnect layers or between an interconnect layer and the top or bottom transistor tiers (e.g., the active layers of the SRAM device).

Reference is herein made to a "bottom frontside interconnect layer". The bottom frontside interconnect layer refers to the bottom-most frontside interconnect layer arranged over the top transistor tier. That is, the first frontside interconnect layer following the top transistor tier, as seen along the Z direction.

Reference will in the following further be made to an "upper" frontside interconnect layer and "first intermediate" and "second intermediate" frontside interconnect layers. The upper frontside interconnect layer refers to a frontside interconnect layer arranged over each one of the bottom and intermediate frontside interconnect layers. Accordingly, the first and second intermediate frontside interconnect layers refer to respective frontside interconnect layers arranged between the bottom and upper frontside interconnect layers. More specifically, the second intermediate frontside interconnect layer is arranged over the first intermediate frontside interconnect layer.

The bottom, first and second intermediate, and upper frontside interconnect layers may in particular be consecutive frontside interconnect layers, i.e., corresponding to the four bottom-most frontside interconnect layers of the frontside interconnect structure. Hence, each one of these consecutive interconnect layers may be spaced apart (only) by a respective via layer.

The labels "bottom", "first intermediate", "second intermediate" and "upper" may be applied correspondingly to the respective via layers, with a corresponding meaning. Thus, the bottom via layer refers to the bottom-most via layer abutting the contacts and gates of the top transistor tier. The bottom via layer may comprise both gate vias ("VG") and contact vias ("VDT"). A gate via VG is a via contacting ("landing on") a gate of a transistor structure, typically of the top transistor tier. A contact via VDT is a via contacting a S/D contact of a transistor structure, typically of the top transistor tier.

For conciseness, the bottom, first intermediate, second intermediate and upper frontside interconnect layers of the frontside interconnect structure may be denoted M0, M1, M2 and M3, respectively, where the index indicates the position of the layer in the stack, counted from the bottom-most interconnect layer. The via layers may in a corresponding manner be denoted V0, V1, V2 and V3. While this convention has been adopted to streamline the following description, it is to be understood that these specific labels are not to be construed as limiting the applicability to implementations wherein such specific labels are used for the various layers of the device. For instance, other conventions exist. For example, the labels MINT and VINT are in some cases used instead of M0 and V0, to denote the bottom-most frontside interconnect and via layers, respectively. Where the VINT label is used, the second bottom most frontside interconnect layer may instead of being indexed M1, be indexed M0, with a corresponding re-labelling of the successive higher layers.

Reference will in the following further be made to a bottom layer of first backside interconnect layer, wherein "bottom" and "first" is used to denote that the backside interconnect layer is the backside interconnect layer closest to the substrate or bottom transistor tier. The bottom backside interconnect layer may be denoted MB0. Accordingly, the MB1 layer refers to a backside interconnect layer being second closest to the substrate.

The backside interconnect layer may like the frontside interconnect layer further comprise one or more backside via layers. For instance, the backside interconnect layer may be coupled to the transistor structures by vias of a bottom or first backside via layer, arranged between the backside interconnect layer and the substrate or bottom transistor tier. The bottom via layer may be denoted VB0 and the label "VBD" may be used to refer to a via of the VB0 layer.

The interconnects (e.g., lines, line segments, contacts) of an interconnect layer may be arranged in (or along) any one of a set of routing tracks in the interconnect layer. In the present disclosure, the routing tracks of each layer referred to are assumed to be unidirectional, extending in parallel in either the X direction or the Y direction and being arranged with a substantially uniform pitch, or at least regular pitch. As illustrated in the drawings, the routing tracks of the M0 layer ("M0 tracks") extend in parallel in the X direction, and hence in the row direction and width dimension of the cells. The routing tracks of the M1, M2 and M3 layers ("M1, M2, and M3 tracks") in turn extend in parallel in the Y direction, X, direction and Y direction, respectively.

As per se is known to the skilled person, an interconnect such as a line or line segment arranged in any given routing track need not extend along the length of the track, or the full width or height dimension of an associated bit cell, half cell or cell row but need only be disposed to define an overlap with respect to the structures that are to be interconnected. Further, some routing tracks may even be unused, depending on the routing requirements of the specific circuit cell implementation.

By the term "track height" of a bit cell or half cell is herein meant the number of M0 routing tracks associated with cell or half cell (i.e., arranged within its footprint such that the routing tracks may be used for signal routing within/to/from the cell or half cell).

By the term "cell height" is herein meant the dimension of a bit cell or half cell as measured along the Y direction. Hence, the cell height corresponds to the M0 track pitch times the track height of the cell or half cell.

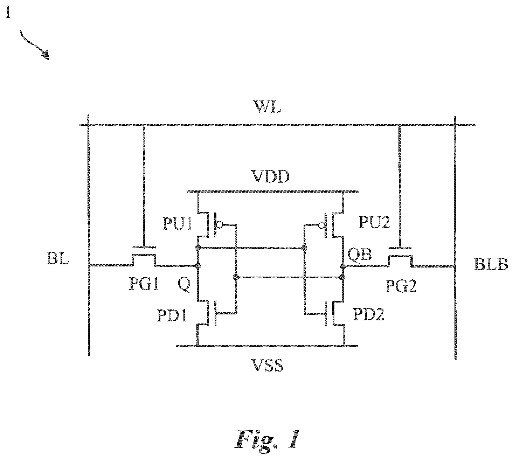

Fig. 1 depicts by way of example the circuit layout of a conventional 6T SRAM bit cell. BL and BLB denotes a bit line and a bit line bar associated with the bit cell. WL denotes a word line associated with the bit cell. The bit line and bit line bar are shared by bit cells along a same row. The word line is shared by bit cells along a same column. PG1 and PG2 denotes first and second pass transistors. PU1 and PU2 denotes first and second pull-up transistors coupled to the pull-up power rail denoted VDD. PD1 and PD2 denotes first and second pull-down transistors coupled to the pull-down power rail denoted VSS. The first pull-up and pull-down transistors are configured as a first inverter PD1/PU1. The second pull-up and pull-down transistors are configured as a second inverter PD2/PU2. The first and second inverters PD1/PU1 and PD2/PU2 are cross-coupled to each other. The first inverter PD1/PU1 and the first pass gate PG1 are comprised in a first half cell of the bit cell and are interconnected to define a first storage node Q of the first half cell. The second inverter PD2/PU2 and the second pass gate PG2 are comprised in a second half cell of the bit cell and are interconnected to define a second storage node QB of the second half cell.

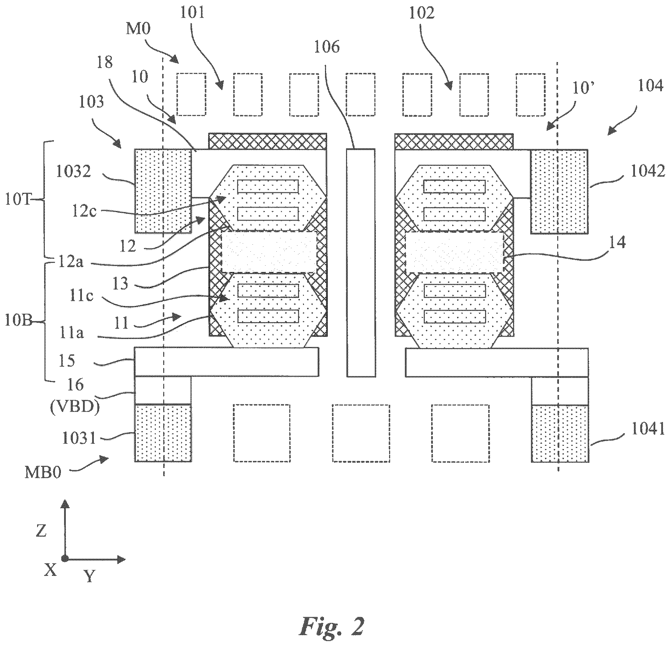

As mentioned above, the SRAM bit cells to be disclosed in the following are based on the double-row configuration. Examples of double-row configurations will now be discussed with reference to Fig. 2-5.

Fig. 2 schematically shows an example of two corresponding transistor structures 10, 10' comprised in respective transistor rows 101, 102 of a device. The respective transistor rows may in turn be comprised in respective cell rows of the device. Each transistor structure 10, 10' is a stacked transistor structure in the form of a CFET and comprises a bottom device 11 and a top device 12 stacked on top of the top device. The bottom device 11 is comprised in a bottom transistor tier 10B and the top device 12 is comprised in a top transistor tier 10T.

The reference sign M0 indicates with dashed outline rectangular boxes a set of M0 tracks of the M0 layer of the frontside interconnect structure arranged over the transistor rows 101, 102. The reference sign MB0 correspondingly indicates a set of MB0 tracks of the MB0 layer of the backside interconnect structure.

The view is a partial cross section-partial projection, to allow a simultaneous view of respective S/D regions and channel regions of the transistor structures 10, 10'. Reference will in the following mainly be made to the transistor structure 10, however the discussion applies correspondingly to the transistor structure 10' or the other row.

The bottom device 11 comprises, as shown, a bottom S/D feature or region 11a (e.g., an epitaxial S/D body) and a bottom channel structure 11c (e.g., one or more stacked nanosheets, typically Si or SiGe-based) extending in the first direction X between the bottom S/D region 11a and an opposite bottom S/D region of the bottom transistor tier 10B.

The top device 12 comprises as shown corresponding features, a top S/D feature or region 12a and a top channel structure 12c (e.g., one or more stacked nanosheets) extending in the first direction X between the top S/D region 12a and an opposite top S/D region of the top transistor tier 10T.

The CFET device 10 comprises a S/D contact structure comprising a bottom S/D contact or contact portion 15 coupled to (by abutting) the bottom S/D region 11a, and a top S/D contact or contact portion 18 coupled to (by abutting) the top S/D region 12a. The top S/D contact 18 is vertically separated from the bottom S/D contact 15. The bottom and top S/D contacts 15, 18, and the bottom and top S/D regions 11a, 11b may as schematically shown be separated by an intermediate insulating layer portion 14 (e.g., an inter-layer dielectric such as silicon oxide). In Fig. 2, the bottom S/D contact 15 is shown as a layer-like feature abutting the bottom S/D region 11a from below. However, this is just an example and the bottom S/D contact 15 may also be formed to wrap around the bottom S/D region 11a, fully or partly. This applies correspondingly to the top S/D contact 18.

The CFET 10 further comprises a gate 13 shared by the bottom and top devices 11, 12. The gate 13 is arranged to surround the bottom and top channel structures 11c, 12c along a channel region, e.g., completely in a gate-all-around (GAA) fashion.

The two transistor rows 101, 102 are surrounded by a pair of power rail structures 103, 104, extending along opposite side of the transistor rows.

Each power rail structure 103, 104 comprises a bottom power rail 1031, 1041 and a top power rail 1032, 1042 stacked over the respective bottom power rail. The bottom power rails 1031, 1041 may be configured as pull-up voltage rails (VDD) and the top power rails 1032, 1042 may be configured as pull-down voltage rails (VSS), or vice versa (depending on the channel types of the bottom and top devices 11, 12), such that each power rail structure 103, 104 may supply both a pull-up and pull-down voltage to the respective neighboring CFET 10, 10'. Thereby, each CFET 10, 10' may be configured as a respective inverter. The S/D contact structure 15, 18 may hence in the depicted configuration be referred to as a power rail contact structure, comprising a bottom power rail contact 15 and a top power rail contact 18.

In the illustrated example, the bottom power rails 1031, 1041 are arranged in respective MB0 tracks in the MB0 layer. The bottom power rail 1031 is coupled to the bottom S/D region 11a of the bottom device 11. The coupling is realized by a backside via VBD 16 abutting a portion of the bottom S/D contact 15 extending laterally along the Y direction to overlap the bottom power rail 1031. The bottom power rail 1041 may as shown be coupled to the bottom device of the CFET 10' in a corresponding manner.

The top power rails 1032, 1042 are arranged in the top transistor tier 10T (i.e., below the M0 layer) and coupled to the respective S/D regions. The top power rail 1032 is coupled to the top S/D region 12a of the top device 12. The coupling is realized by the top S/D contact 18 extending laterally along the Y direction to abut the top power rail 1032 from the side. The top power rail 1042 may as shown be coupled to the top device of the CFET 10' in a corresponding manner.

In accordance with the double-row configuration, there is no power rail structure between the two transistor rows R1, R2. Instead, the rows R1, R2 are separated by a spacer track which may be used for other purposes than power distribution.

In the illustrated example, the spacer track accommodates a signal routing structure 106 in the form of an interconnect arranged in the bottom and top transistor tiers 10B, 10T. The signal routing structure 106 is substantially centered between the transistor rows R1, R2 and CFETs 10, 10'.

The shared signal routing structure 106 may be a substantially pillar or wall-shaped and vertically oriented metal interconnect. The signal routing structure 106 may extend continuously between the transistor rows R1, R2, along the full length thereof, or along a part thereof (segments). The signal routing structure 106 may also, depending on implementation, be segmented into a row of respective interconnect segments (e.g., each being a substantially wall-shaped and vertically oriented metal interconnect segment) spaced apart along the X direction. While not being the case for the CFETs 10, 10' shown in Fig. 2, the interconnect segment(s) of the signal routing structure 106 may be coupled to one or more bottom and/or top devices of the transistor structures of the transistor rows R1, R2.

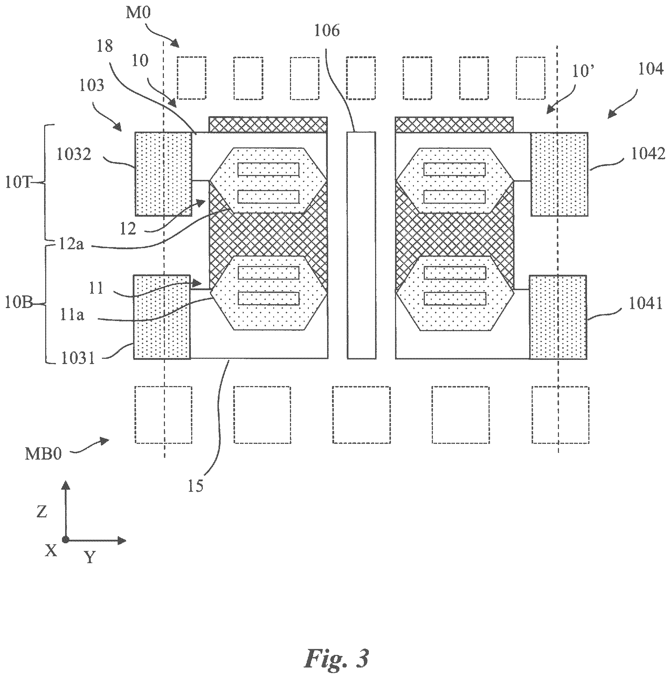

Fig. 3 illustrates a further implementation of a double-row configuration, wherein the bottom power rails 1031, 1041 instead are arranged in the bottom transistor tier 10B. The coupling between the bottom power rail 1031 and the bottom S/D region 11a of the bottom device 11 is in this implementation realized by the bottom S/D contact 15 extending laterally along the Y direction to abut the bottom power rail 1031 from the side. The bottom power rail 1041 may as shown be coupled to the bottom device of the CFET 10' in a corresponding manner. The MB0 tracks may in this case be used for other purposes than accommodating power rails, such as for signal routing.

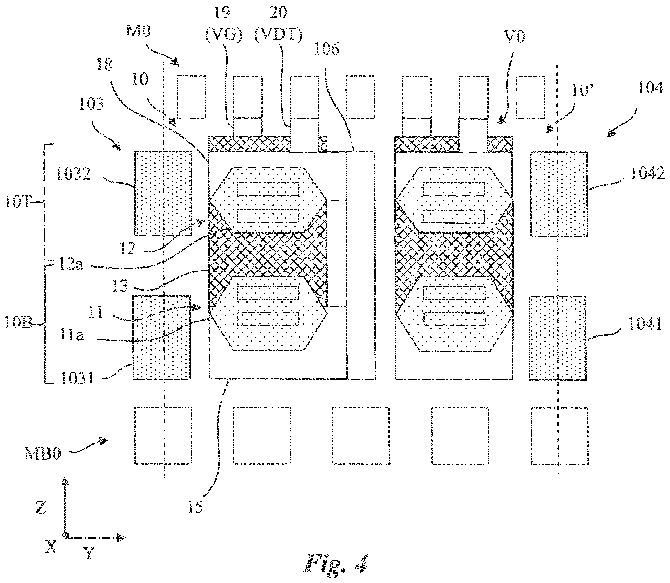

Fig. 4 illustrates a further implementation of a double-row configuration, wherein the bottom and top S/D regions 11a, 11b of the CFET 10, instead of being coupled to the power rail structure 103, are interconnected by an interconnect segment of the signal routing structure 106. The coupling to the signal routing structure 106 may be realized by each of the bottom and top S/D contacts 15, 18 extending laterally along the Y direction to abut the signal routing structure 106 from the side.

Thereby, the interconnected bottom and top S/D contacts 15, 18 and interconnect segment 106 may be configured to define a shared S/D contact structure interconnecting the bottom and top S/D regions 11a, 12b of the CFET 10.

As may be appreciated, the CFET 10 may in this case for instance be coupled to the power rail structure 103 at the opposite side of the gate 13.

As further shown in Fig. 4, the gate 13 of the CFET 10 may be coupled to an interconnect arranged in an overlapping M0 track by a gate via VG 19 of the V0 via layer.

As further shown in Fig. 4, the top S/D contact 18 may be coupled to an interconnect arranged in an overlapping M0 track by a contact via VDT 20 of the V0 layer.

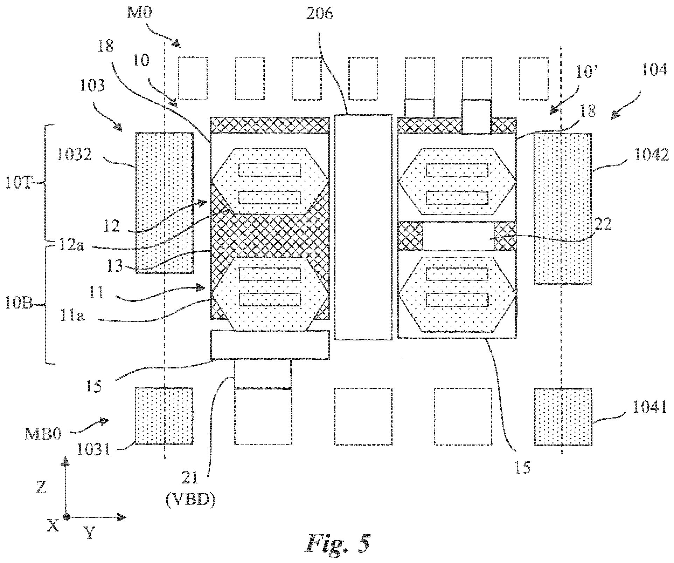

Fig. 5 illustrates a further implementation of a double-row configuration, wherein the spacer track is absent of a signal routing structure and the transistor rows R1, R2 instead are separated by an insulating wall structure 206 arranged in the bottom and top transistor tiers 10B, 10T and extending continuously along the spacer track, as an insulating and physical partition between the transistor rows.

Fig. 5 further illustrates that the bottom S/D region 11a may be coupled to an interconnect in a MB0 track underneath the bottom S/D region 11a by a backside via VBD 21 abutting the interconnect in the MB0 track and the S/D bottom contact 15.

Fig. 5 further illustrates another implementation of a shared S/D contact structure where the bottom and top S/D contact (portions) 15, 18 of the CFET 10' are interconnected by an intermediate S/D merge layer 22. The intermediate S/D merge layer 22 may be a metal layer 22, formed (e.g., deposited) on top of the bottom S/D contact portion 15 during fabrication, e.g., prior to or when forming the top S/D contact 18.

Fig. 5 further illustrates another implementation of the stacked power rail structures 103, 104, wherein the bottom power rails 1031, 1041 are arranged in respective MB0 tracks in the MB0 layer and the top power rails 1032, 1042 are formed with a greater height (along the Z direction) and thus is arranged in both the top transistor tier 10T and in the bottom transistor tier 10B (at least partly).

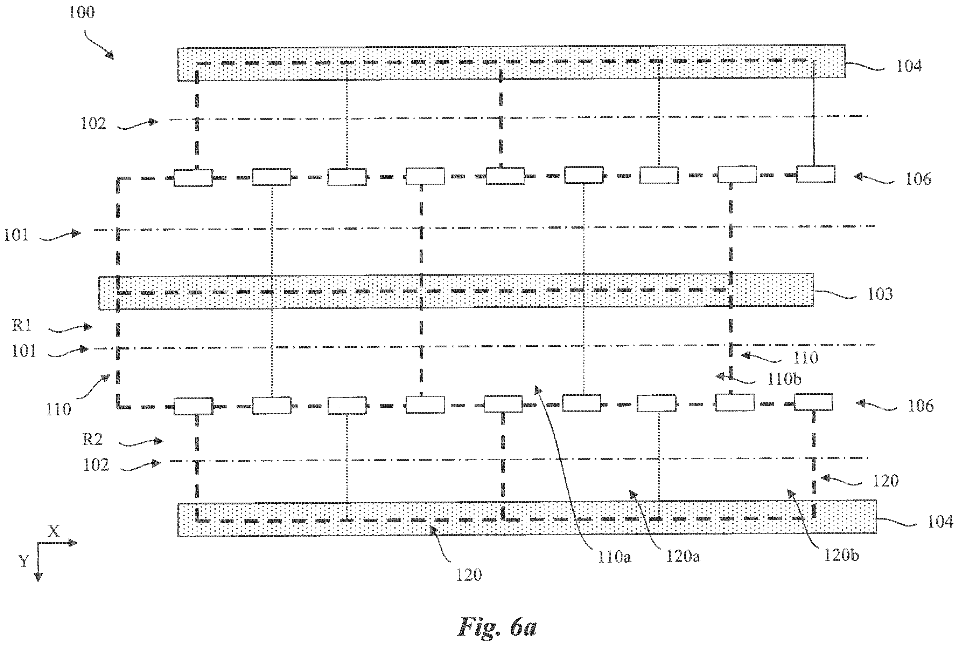

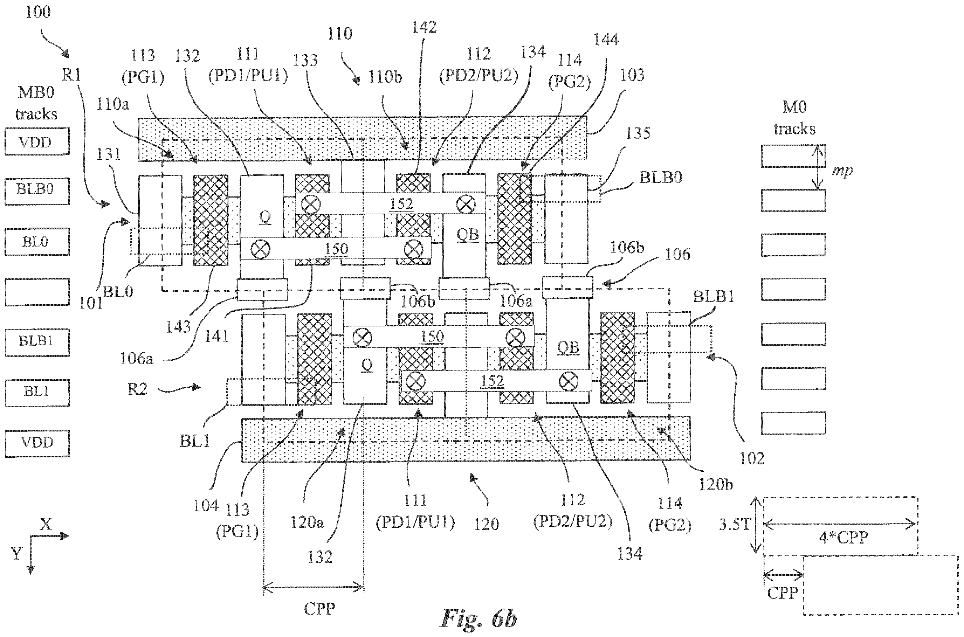

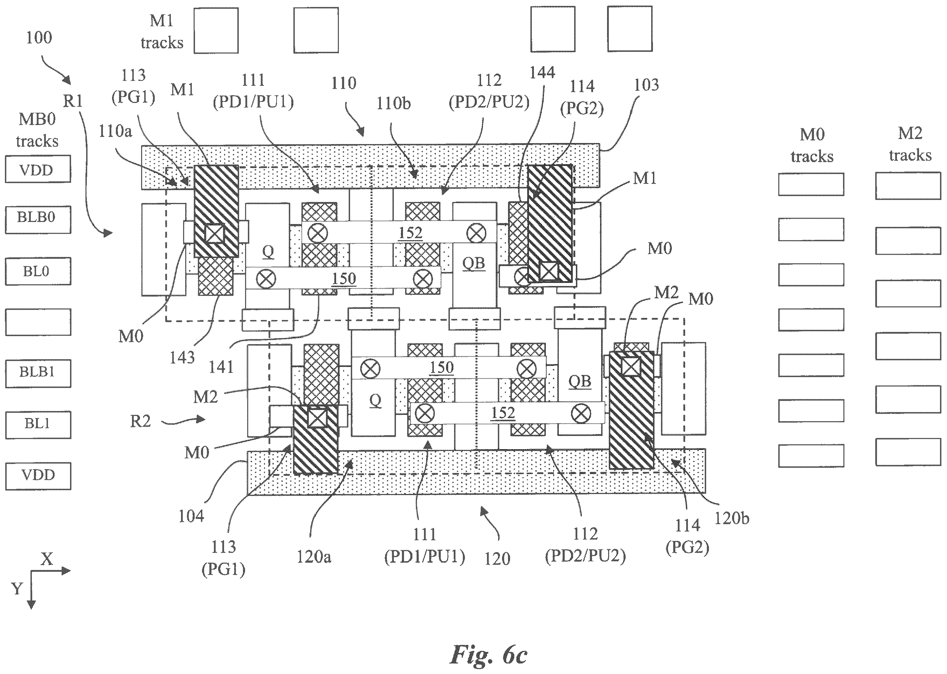

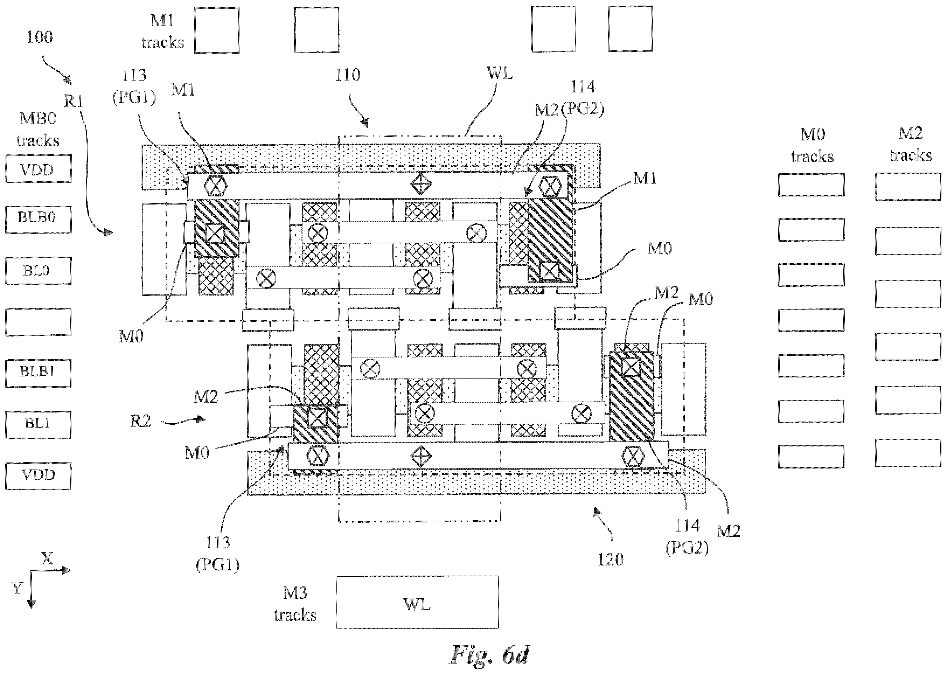

A first through fifth example implementation of an SRAM device based on the double-row configuration will in the following be disclosed with reference to Fig. 6a-d, 7a-d, 8a-d, 9a-c and 10a-c. Fig. 6a, 7a, 8a, 9a and 10a each show an overall layout of transistor rows, cell rows, spacer tracks and power rail structures of respective example SRAM devices 100, 200, 300, 400 and 500. Fig. 6b-d, 7b-d, 8b-c, 9b-c and 10b-c in turn show in detail a layout of the respective bit cells. It is to be noted that Fig. 6-10a may show only a small subset of a considerably larger array of SRAM bit cells of the respective SRAM devices 100. Hence, each SRAM device 100, 200, 300, 400 and 500 may in general comprise a much greater number of correspondingly configured transistor rows, cell rows, spacer tracks and power rail structures.

In the figures, like reference signs will be used to refer to like elements, unless stated otherwise. For instance, reference signs 101, 102 refer to first and second transistor rows. Reference signs R1, R2 refer to first and second cell rows. Reference signs 103, 104 refer to first and second power rail structures. Reference signs 110, 120 refer to a first bit cell and a second bit cell, respectively. Reference signs 110a and 120a refer to a first half cell of the first and second bit cells 110, 120, respectively. Reference signs 110b and 120b refer to a second half cell of the first and second bit cells 110, 120, respectively. Throughout the drawings, dashed lines are used to schematically indicate boundaries or edges of the bit cells while dotted lines are used to schematically indicate a boundary between the half cells of a bit cell. Furthermore, a crossed circle indicates the horizontal location of a V0 via (either a gate via VG or contact via VDT), a crossed square indicates the horizontal location of a V1 via, a crossed hexagon indicates the horizontal location of a V2 via, a crossed diamond indicates the horizontal location of a V3 via and a crossed pentagon indicates a horizontal location of a multi-level via between the M2 and M0 layers.

Accordingly, as shown in Fig. 6-10a, each SRAM device 100, 200, 300, 400 and 500 comprises a plurality of first and second rows of transistor structures 101, 102 extending in parallel in the X direction and spaced apart in the Y direction. The X direction corresponds to a channel direction of the transistor structures. Some of the transistor structures of each transistor row 101, 102 are configured as inverters PD1/PU1, PD2/PU2 and may thus be stacked transistor structures formed as CFETs comprising a bottom transistor structure (bottom device) arranged in the bottom transistor tier and a top transistor structure (top device) arranged in the top transistor tier. Some of the transistor structures of each transistor row 101, 102 are configured as pass gates PG1, PG2 and may comprise either a bottom transistor structure (bottom device) arranged in the bottom transistor tier or a top transistor structure (top device) arranged in the top transistor tier.

Each SRAM device 100, 200, 300, 400 and 500 comprises a plurality of bit cells 110, 120 arranged in a plurality of first and second cell rows R1, R2. Each first cell row R1 comprises a respective first transistor row 101. Each second cell row R2 comprises a respective second cell row 102.

Each SRAM device 100, 200, 300, 400 and 500 comprises a plurality of first and second power rail structures 103, 104 extending in parallel in the X direction. The first and second power rail structures 103, 104 may be configured in accordance with any one of the examples shown in Fig. 2-5. Hence, the top power rail 1032, 1042 of each power rail structure 103, 104 may be arranged in the top transistor tier, and the bottom power rail 1031, 1041 may be arranged in either the bottom transistor tier or in a backside routing track of a backside interconnect layer, such as an MB0 track of the MB0 layer. In either case, each power rail structure 103, 104 is as shown arranged to overlap and extend (bottom or top) edges or boundaries of the cell rows.

The power rail structures 103, 104 are interleaved with the transistor rows R1, R2 such that a respective pair of neighboring first and second cell rows R1, R2 comprising a respective pair of neighboring first and second transistor rows 101, 102 (i.e., "a double-row") is arranged between each pair of consecutive first and second power rail structures 103, 104. A respective spacer track, absent of any power rail structure, is thus defined between each first and second transistor row 101, 102 of a double-row.

In the SRAM devices 100, 200, 300 each spacer track is used to accommodate a row of interconnect segments 106 for interconnecting bottom and top S/D contact portions of inverters. In the SRAM devices 400, 500 each spacer track is absent of conductive structures and instead merely used to provide physical and electrical separation between the transistor rows 101, 102 of each double-row.

With reference to any one of Fig. 6b, 7b, 8b, 9b and 10b, each bit cell 110, 120 comprises a first half cell 1 10a, 120a and a second half cell 1 10b, 120b. Each first half cell 110a comprises a first inverter PD1/PU1, and a first pass gate PG1 coupled between the first inverter and a bit line BL (where the same terminology is used as in Fig. 1). Each second half cell 110b, 120b comprises a second inverter PD2/PU2 cross-coupled with the first inverter PD1/PU1, and a second pass gate PG2 coupled between the second inverter and a bit line bar BLB.

The first inverter PD1/PU1 comprises a first stacked transistor structure (first CFET) 111. The second inverter PD2/PU2 comprises a second stacked transistor structure (second CFET) 112. The first and second CFETs 111, 112 may each have a structure corresponding to the CFETs 10, 10' of Fig. 2-5. Thus, the first CFET 111 may comprise a first bottom device (first bottom transistor structure) corresponding to the bottom device 11 of the CFET 10, and a first top device (first top transistor structure) corresponding to the top device 12 of the CFET 10. Likewise, the second CFET 112 may comprise a second bottom device (second bottom transistor structure) corresponding to the bottom device 11 of the CFET 10, and a second top device (second top transistor structure) corresponding to the top device 12 of the CFET 10. The first CFET 111 has a first shared gate 141 shared by its first bottom and top devices. The first shared gate 141 is arranged between first and second bottom and top S/D regions of the first inverter PD2/PU2 (and first CFET 111). The second CFET 112 has a second shared gate 142 shared by its second bottom and top devices. The second shared gate 142 is arranged between first and second bottom and top S/D regions of the second inverter PD2/PU2 (and second CFET 112).

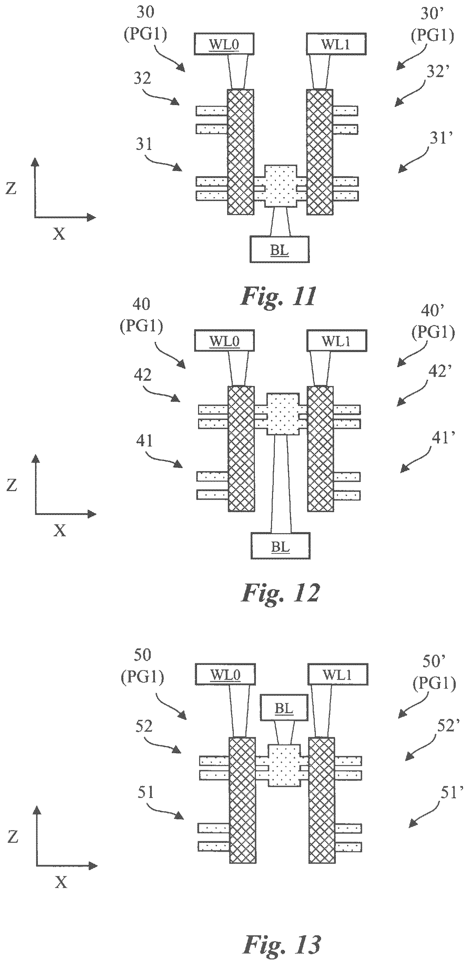

As mentioned above, pass gates may be implemented by a single transistor. Hence, the third and fourth transistor structures 113, 114 of the first and second pass gates PG1, PG2, respectively, of each bit cell 110, 120 may be a third bottom or top transistor structure 113, and a fourth bottom or top transistor structure 114, respectively. The third and fourth transistor structures (bottom or top devices) 113, 114 may however still be comprised in a respective stacked transistor structure, wherein the device not configured as pass gate is configured as a dummy device. Various implementations of a dummy device are discussed below with reference to Fig. 11-13. In either case, in the following example implementations of SRAM devices 100, 200, 300, 400, 500, the first and second pass gates PG1, PG2 will be assumed to be implemented by third and fourth bottom devices 113, 114, respectively. It is however, to be noted that it is equally possible to implement the SRAM devices 100, 200, 300, 400, 500 using pass gates implemented by top devices.

In each of the SRAM devices 100, 200, 300, 400, 500, the first pass gate PG1 has a gate 143 arranged between first and second S/D regions of the first pass gate PG1 (and third bottom device 113). The second pass gate PG2 has a gate 144 arranged between first and second S/D regions of the second pass gate PG2 (and the fourth bottom device 114).

The second S/D region of each first pass gate PG1 is abutted by a S/D contact configured as a bit line (BL) contact 131. The second S/D region of each second pass gate PG2 is abutted by a S/D contact configured as a bit line bar (BLB) contact 135. Where the bit lines and bit line bars are arranged in a backside interconnect layer, the BL contact 131 and BLB contact 135 may be coupled to their associated bit line and bit line bar by a respective backside via VBD like the VBD 21 in Fig. 5.

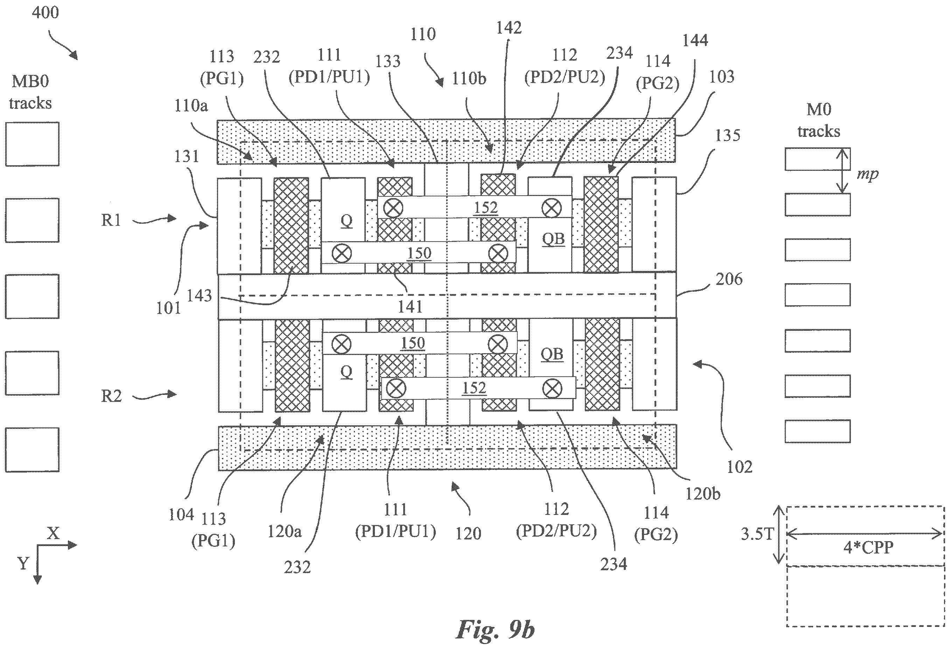

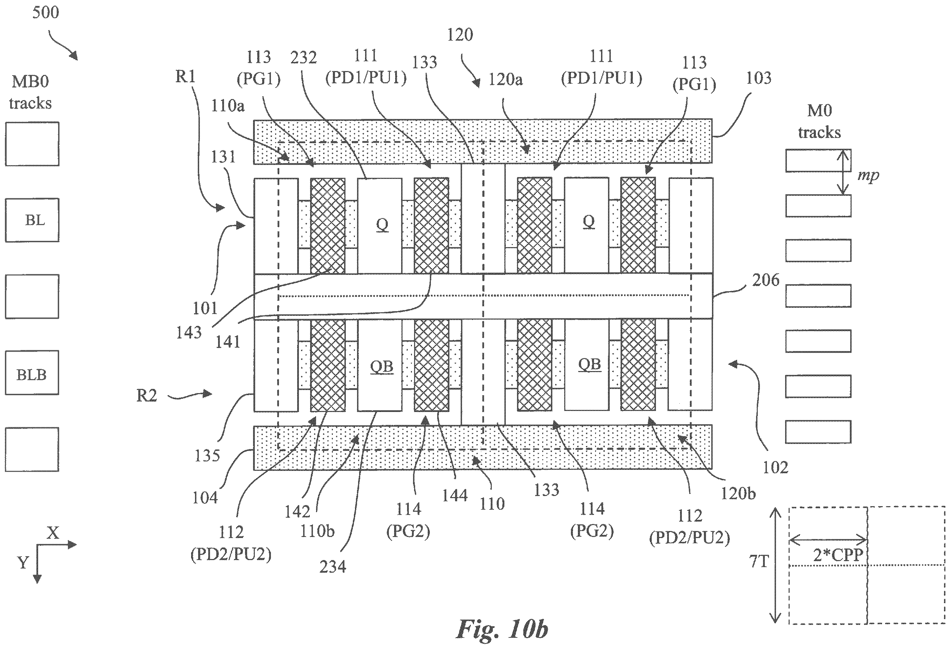

The first S/D region of the first pass gate PG1 and the first bottom and top S/D regions of the first inverter PD1/PU1 of each first half cell 110a, 120a are interconnected by a first shared S/D contact structure (reference sign 132 in Fig. 6b, 7b and 8b and reference sign 232 in Fig. 9b and 10b) arranged between the first inverter PD1/PU1 and the first pass gate PG1 of the half cell. Correspondingly, the first S/D region of the second pass gate PG2 and the first bottom and top S/D regions of the second inverter PD2/PU2 of each second half cell 110b, 120b are interconnected by a second shared S/D contact structure (indicated by reference sign 134 in SRAM devices 100, 200, 300 and reference sign 234 in SRAM devices 400, 500) arranged between the second inverter PD2/PU2 and the second pass gate PG2 of the half cell.

The shared S/D contact structures 132, 134 differ from the shared S/D contact structures 232, 234 in that in each shared S/D contact structure 132, 134, the respective bottom and top S/D contact portions are interconnected by an interconnect segment of a row of interconnect segments 106 (e.g., as shown in Fig. 4), while in each shared S/D contact structure 232, 234, the respective bottom and top S/D contact portions are interconnected by a S/D contact merge layer (not visible in the top down views of SRAM device 400 or 500, but corresponding to S/D contact merge layer 22 as shown in Fig. 5).

The second bottom and top S/D regions of each first and second inverter PD1/PU1 and PD2/PU2 is abutted by a S/D contact structure or power rail contact structure coupling the second bottom S/D regions to a bottom power rail and the second top S/D regions to a top power rail of a power rail structure 103 or 104. The S/D contact structures / power rail contact structures are in each of Fig. 6b, 7b, 8b, 9b and 10b indicated by the same reference sign 133, as the power rail contact structure 133 in some of the SRAM implementations are shared by the first and second inverter PD1/PU1 and PD2/PU2 of a first and second half cell. The power rail contact structure 133 may be implemented and coupled to the respective power rails like the bottom and top S/D contacts 15, 18 as shown in Fig. 2 or Fig. 3, depending on whether the bottom power rail is in the backside side interconnect layer MB0 (like in Fig. 2) or in the bottom transistor tier (like in Fig. 3).

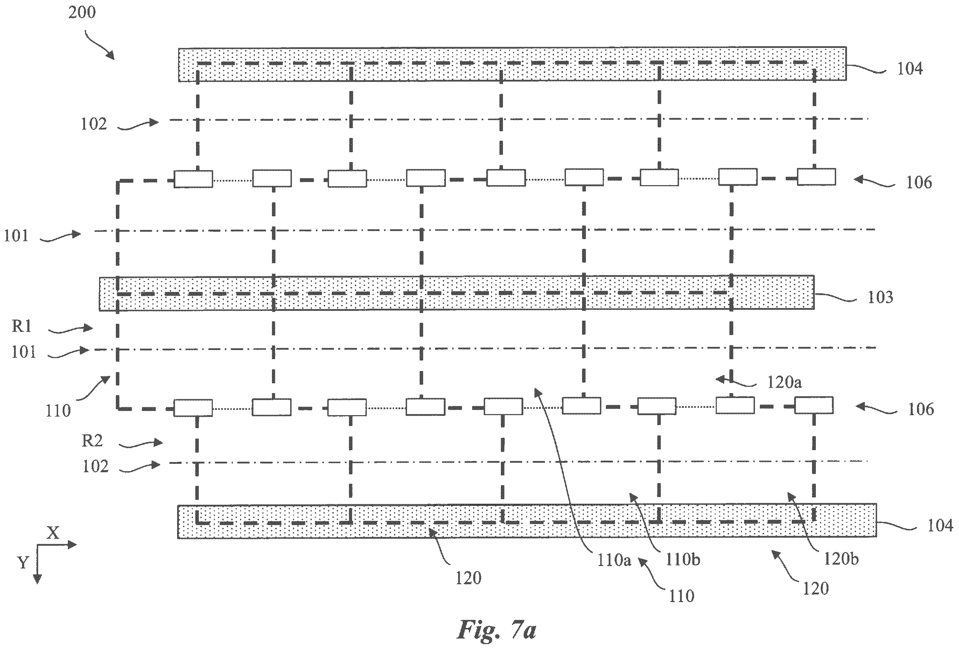

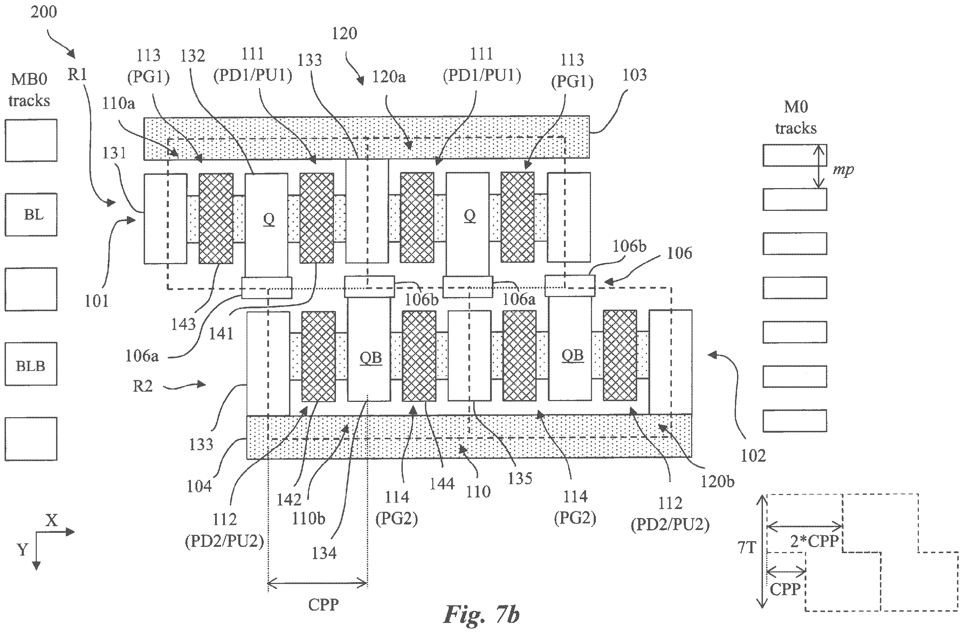

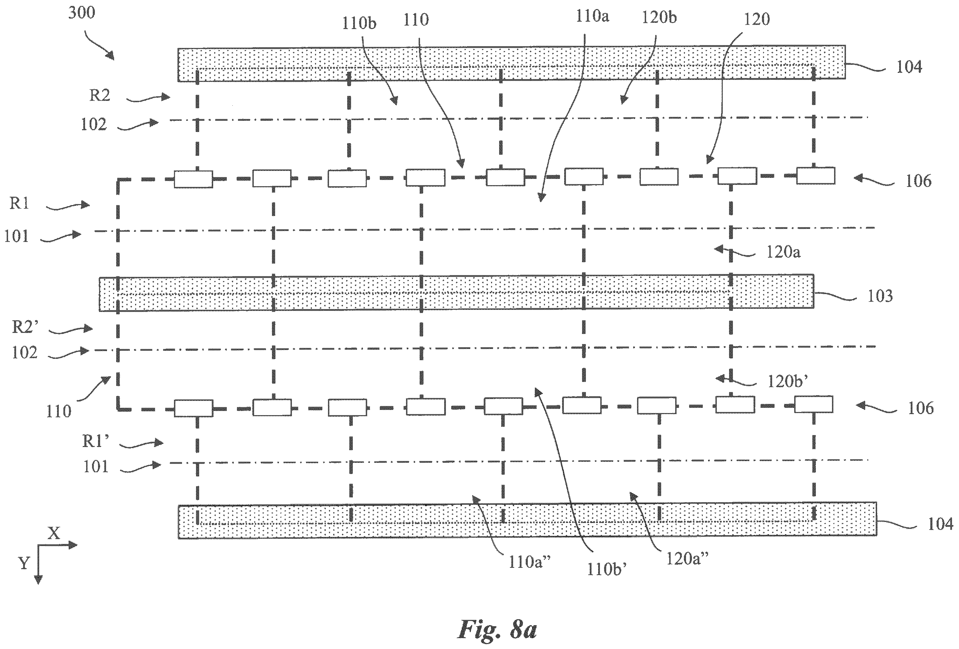

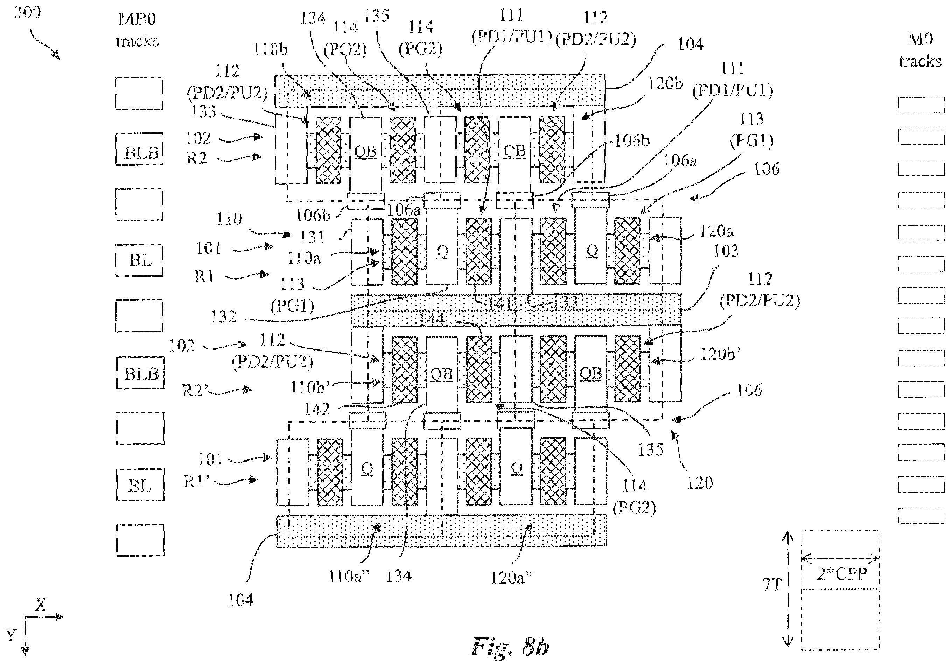

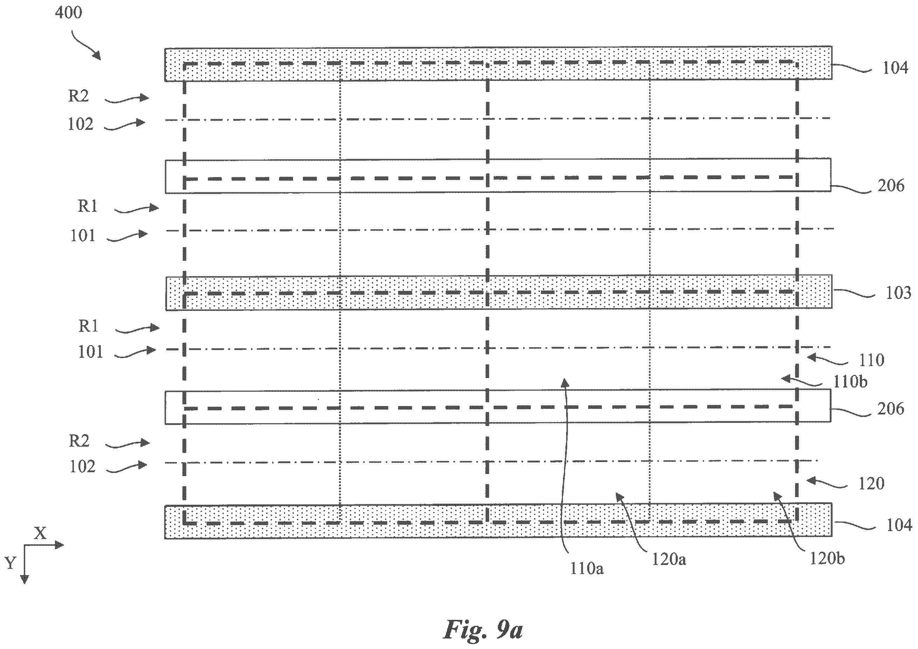

As will be further discussed below, the first and second half cells 1 10a-b and 120a-b of each respective bit cell 110, 120 may be arranged in a same cell row (as in the SRAM device 100 of Fig. 6a and the SRAM device 400 of Fig. 9a) or in different cell rows (as in the SRAM device 200 of Fig. 7a, the SRAM device of Fig. 8a, and the SRAM device 500 of Fig. 9a). However, in either case, the half cells have a cell width of 2CPP and a cell height of 3.5T, corresponding to a bit cell area of either 4CPP*3.5T (as indicated in Fig. 6b for SRAM device 100, and in Fig. 9b for SRAM device 400) or 2CPP*7T (as indicated in Fig. 7b for SRAM device 200, in Fig. 8b for SRAM device 300, and in Fig. 9b for SRAM device 500).

Further details of the various SRAM device 100, 200, 300, 400, 500 will now be discussed with reference to their associated drawings.

Fig. 6a-d schematically shows the SRAM device 100 according to the first example implementation. As mentioned above, the SRAM device 100 is an example of an implementation where the spacer tracks are used to accommodate a row of interconnect segments 106, for interconnecting top and bottom S/D contacts of the inverters PD1/PU1, PD2/PU2 of the bit cells 110, 120. Each row of interconnect segments 106 extends along the shared boundary between a respective pair of neighboring cell rows R1, R2.

Fig. 6b-d show in detail the layout of the bit cells 110, 120 in Fig. 6a. Fig. 6c and 6d show the bit cells 110, 120 of Fig. 6b overlaid by further frontside via and interconnect layers for coupling the bit cells 110, 120 to bit lines and bit line bars BL, BLB and word lines WL.

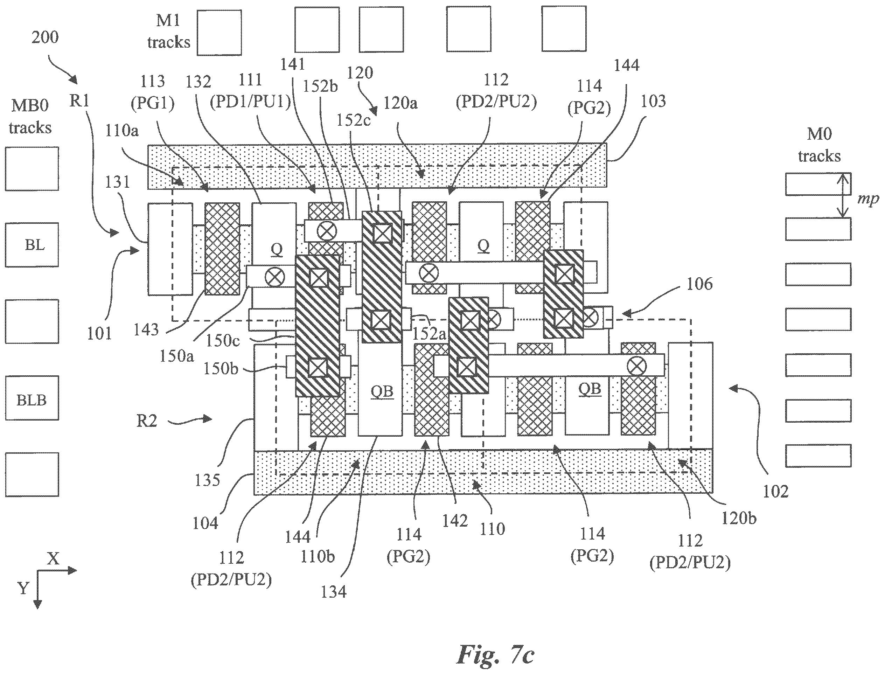

The locations of a set of MB0 tracks, M0 tracks, M1 tracks, M2 tracks and M3 tracks associated with the cell rows R1, R2 are schematically indicated by respective sets of rectangles adjacent to the bit cell area. As mentioned above, the MB0 tracks, M0 tracks and M2 tracks extend in the X direction, along the cell rows R1, R2. The M1 and M3 tracks extend in the Y direction, across the cell rows R1, R2. The pitch of the M0 tracks is *mp* (indicated in Fig. 6b). The track height of each cell row R1, R2 is 3.5T (in number of M0 tracks) and the height is 3.5**mp.* The width of each bit cell 110, 120 is 2CPP. The MB0 tracks, M0 tracks and M2 tracks may as indicated typically be arranged at respective uniform pitches. For illustrational simplicity, Fig. 6c-d only shows the M1 routing tracks used in the bit cell layouts and accordingly omits un-used M1 routing tracks. For example, the pitch of the M1 routing tracks may be such that the ratio of the M1 track pitch to CPP is approximately 3:2, meaning that there can be up to three M1 routing tracks within a 2 CPP width. This applies correspondingly to the M1 routing tracks depicted in Fig. 7c-d, 8c-d, 9c and 10c.

In the SRAM device 100, the first and second half cells 1 10a-b, 120a-b of each bit cell 110, 120 are as shown comprised in a same cell row R1 or R2. Accordingly, the first and second cell rows R1, R2 of each double-row configuration are first and second rows of bit cells, such that each cell row R1, R2 comprises both first half cells 110a, 120a and second half cells 110b, 120b.

The first and second cell rows R1, R2 are as shown arranged in a staggered fashion. More specifically, as shown in detail in Fig. 6b, in each pair of neighboring first and second cell rows R1, R2, the second cell row R2 is displaced relative the first cell row R1 along the first direction X by one CPP. Accordingly, the shared S/D contact structures 132, 134 associated with the half cells 110a, 110b of the first cell row R1 are displaced relative the shared S/D contact structures 132, 134 associated with the half cells 120a, 120b of the second cell R2 row by one CPP.

This in turn allows the interconnect segments of the row of interconnect segments 106 arranged between the cell rows R1, R2 to alternatingly interconnect bottom and top S/D contact portions associated with the first cell row R1 and the second cell row R2. In other words, as shown in Fig. 6b, every first interconnect segment 106a of the row of interconnect segments 106 is comprised in a respective shared S/D contact structure 132, 134 associated with a half cell 110a, 110b of the first cell row R1 and every second interconnect segment 106b of the row of interconnect segments 106 is comprised in a respective shared S/D contact structure 132, 134 associated with a half cell 120a, 120b of the second cell row R2. A pitch of the interconnect segments 106a, 106b may thus at least approximately correspond to the CPP.

Since each cell row R1, R2 comprises both first and second half cells 1 10a-b, 120a-b, and thus both first and second pass gates PG1, PG2, the SRAM device 100 comprises a set of first bit lines and bit line bars BL0, BLB0 for the first cell row R1, and a set of second bit lines and bit line bars BL1, BLB1 for the second cell row R2. The first and second bit lines and bit line bars BL0, BLBO, BL1, BLB1 are arranged in respective MB0 tracks.

The first bit line and bit line bar BL0, BLB0 are arranged below the first cell row R1 and coupled to its first and second pass gates PG1, PG2. The second bit line and bit line bar BL1, BLB1 are arranged below the second cell row R2 and coupled to its first and second pass gates PG1, PG2. The connection may as shown in Fig. 5 be realized by a backside via VBD abutting the BL contact 131 or BLB contact 135 of the respective pass gate PG1, PG2. In the event of a lateral offset along the Y direction between a MB0 track comprising a bit line or bit line bar and the second S/D region of the pass gate PG1 or PG2, the associated BL or BLB contact 131, 135 may be provided with a lateral extension along the Y direction to define an overlap with the offset MB0 track.

The bottom power rails of the power rail structures 103, 104 may in this implementation be arranged in respective MB0 tracks (e.g., like in Fig. 2), surrounding the first and second bit lines and bit line bars BL0, BLBO, BL1, BLB1. It is however also possible to arrange the bottom power rails of the power rail structures 103, 104 in the bottom transistor tier (e.g., like in Fig. 3).

Each bit cell 110, 120 comprises a pair of cross-couple interconnects, configured to cross-couple the first and second inverters PD1/PU1, PD2/PU2. In the illustrated example, each cross-couple interconnect comprises a cross-couple portion 150, 152 arranged in a respective M0 track. The cross-couple portion 150 (and the associated storage node Q) is as shown coupled to the first shared S/D contact structure 132 and the second shared gate 142 of the second inverter PD2/PU2 by a pair of V0 vias (i.e., a VDT via and a VG via). The cross-couple portion 152 is as shown coupled to the second shared S/D contact structure 134 (and the associated storage node QB) and the first shared gate 141 of the first inverter PD1/PU1 by a pair of V0 vias (i.e., a VDT via and a VG via).

While the bit cells 110, 120 in Fig. 6b are displaced with respect to each other, they may still be considered to be comprised in a same column of bit cells (Y corresponding to the column direction), as they are coupled to and arranged along a same word line WL. The word line connection will now be described with reference to Fig. 6c-d.

As shown in Fig. 6d, the word line WL is arranged in an M3 track. The WL is indicated with a dashed outline to not obscure the underlying features of the bit cells 110, 120. As may be seen from Fig. 6d in conjunction with Fig. 6c, the word line WL is sequentially coupled to the gates 143, 144 of the first and second pass gates PG1, PG2 by interconnects in the M2, M1 and M0 layers and vias of the V3, V2, V1 and V0 via layers.

From Fig. 6c-d, the merits of providing the bit lines BL0, BL1 and bit line bars BLBO, BLB1 in the MB0 layer may be appreciated more fully: Due to the displacement of the first and second cell rows R1, R2, the pass gates PG1, PG2 of the first cell row R1 become displaced relative the pass gates PG1, PG2 of the second cell row R2. As a consequence, had the bit lines BL0, BL 1 and bit line bars BLBO, BLB1 been arranged in four M2 tracks of the M2 layer (which in turn would require corresponding intermediate interconnects in four M1 tracks and four M0 tracks), the displacement of the cell rows R1, R2 could cause a partially staggered relationship between the M1 tracks over the first cell row R1, and the M1 tracks over the second cell row R2. Enforcing alignment of these M1 routing tracks between the cell rows R1, R2 would however risk causing shorting in the M0 layer between the intermediate interconnects in the M0 tracks associated with the word line and bit line and bit line bar connections. Hence, by arranging the bit lines BL0, BL1 and bit line bars BLBO, BLB1 in the MB0 layer, interconnects for bit line and bit line bar connections may be omitted from the M0 layer, such that the M1 routing tracks may be aligned between the cell rows R1, R2.

Fig. 7a-d schematically shows the SRAM device 200 according to the second example implementation. The SRAM device 200, like the SRAM device 100, comprises a row of interconnect segments 106 along each spacer track.

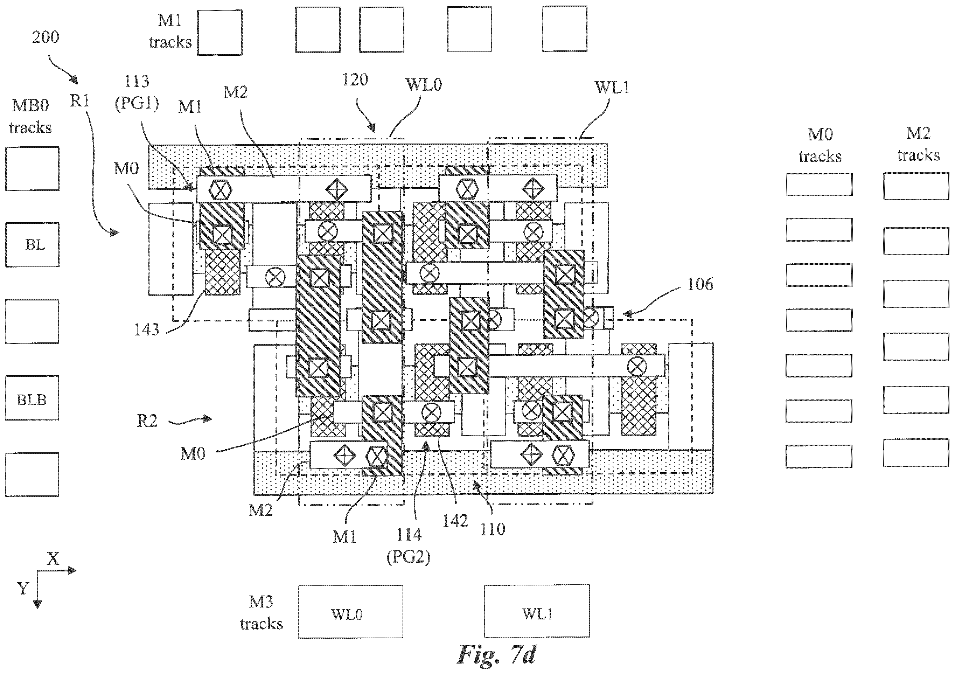

Fig. 7b-d shows in detail the layout of the bit cells 110, 120 in Fig. 7a. Fig. 7c and 7d show the bit cells 110, 120 of Fig. 7b overlaid by further frontside via and interconnect layers for coupling the bit cells 110, 120 to bit lines and bit line bars BL, BLB and word lines WL.

Like in the SRAM device 100, the first and second cell rows R1, R2 of the SRAM device 200 are as shown arranged in a staggered fashion. However, in contrast to the SRAM device 100, the first and second half cells 1 10a-b, 120a-b of each bit cell 110, 120 are comprised in different cell rows R1, R2. More specifically, the first cell row R1 comprises the first half cells 1 10a, 120a of a respective subset of bit cells (e.g., bit cells 110, 120) and the second cell row R2 comprises the second half cells 110b, 120b of the subset of bit cells (e.g., bit cells 110, 120). Consequently, the second half cell 110b of the first bit cell 110 is displaced relative the first half cell 110a of the first bit cell 110 by one CPP. This applies correspondingly to the half cells 120a-b of the second bit cell 120.

Like in the SRAM device 100, the interconnect segments 106a, 106b may as shown alternatingly interconnect bottom and S/D contact portions associated with the first half cells 110a, 120a of the first cell row R1 and the second half cells 110b, 120b of the second cell row R2.

As each cell row R1, R2 only comprises first or second pass gates PG1, PG2, only a bit line BL or bit line bar BLB needs to be provided along each cell row R1, R2. The bit line BL and bit line bar BLB are in the illustrated example arranged in a pair of MB0 tracks. However, it is also possible to arrange the bit line and bit line bar BL, BLB in a pair of M2 tracks, since only a single set of the bit line and bit line bar BL, BLB needs to be accommodated for the two cell rows R1, R2.

Like the SRAM device 100, each bit cell 110, 120 comprises a pair of cross-couple interconnects. However, since in the SRAM device 200 the first and second half cells 1 10a-b, 120a-b of each bit cell are comprised in different cell rows R1, R2, each cross-couple interconnect comprises, as shown in Fig. 7c, a first and second cross-couple portion 150a, 150b and 152a, 152b arranged in respective M0 tracks, and further a third cross-couple portion 150c and 152c arranged in an M1 track and interconnecting the respective first and second cross-couple portions 150a-b and 152a-b by a respective pair of V1 vias.

The word lines are like in the SRAM device 100 arranged in M3 tracks. Fig. 7d shows two word lines WL0, WL1, each coupled to the pass gates PG1, PG2 of a respective column of bit cells using a corresponding combination of interconnects in the M2, M1 and M0 layers and vias of the V3, V2, V1 and V0 via layers.

As shown in Fig. 7b, the order of the first pass gate PG1 and the first inverter PD1/PU1 of the second half cell 120a is flipped or reversed relative to the order of the first pass gate PG1 and the first inverter PD1/PU1 of the first half cell 110a, as seen along the X direction. This allows the power rail contact 133 to be shared between the respective first inverters PD1/PU1 of the half cells 110a, 120a. This pattern may be repeated throughout the first cell row R1. Consequently, the first pass gate PG1 of the first half cell 110a may in a corresponding manner share the BL contact 131 with the first pass gate PG1 of a neighboring first half cell of the first cell row R1. As further shown in Fig. 7b, a similar pattern applies to the second pass gates PG2 and second inverters PD2/PU2 of the second cell row R2.

Fig. 8a-d schematically shows the SRAM device 300 according to the third example implementation. The SRAM device 300, like the SRAM devices 100 and 200, comprises a row of interconnect segments 106 along each spacer track and staggered first and second cell rows. Further, in the SRAM device 300, like in the SRAM device 200, the first and second half cells of each bit cell are comprised in different cell rows. However, in contrast to the SRAM device 200, the first and second half cells of each bit cell are comprised in cell rows on opposite sides of a power rail structure. Accordingly, the first and second cell rows of each double-row configuration of the SRAM device 300 comprises first half cells and second half cells, respectively, of different bit cells.

To facilitate the further discussion of these features with reference to Fig. 8a-d, reference signs R1 and R2 indicate first and second cell rows of a first double-row configuration of the SRAM device 300, while reference signs R1' and R2' indicate first and second cell rows of a second neighboring double-row configuration of the SRAM device 300.

Thus, as shown in Fig. 8a-d, the first cell row R1 of the first double-row configuration comprises respective first half cells 110a, 120a of the first and second bit cells 110, 120 while the second cell row R2 of the first double-row configuration comprises respective second half cells 110b, 120b of a third and fourth bit cell. Further, the second cell row R2' of the second double-row configuration comprises respective second half cells 110b', 120b' of the first and second bit cells 110, 120. The first cell row R1 and the second cell row R2' are arranged on opposite sides of the power rail structure 103. Further, the first cell row R1' of the second double-row configuration comprises respective first half cells 110a", 120a" of a fifth and sixth bit cell.

Consequently, the first cell row R1 comprises the first half cells 1 10a, 120a of a respective first subset of bit cells (comprising bit cells 110, 120) and the second cell row R2 comprises the second half cells 110b', 120b' of a respective second subset of bit cells (comprising the third and fourth bit cells).

While the first half cells 110a, 120a of the first cell row R1 and the second half cells 110b, 120b of the second cell row R2 are offset with respect to each other, the first half cells 110a, 120a of the first cell row R1 are aligned with the corresponding second half cells 1 10a', 120a' of the second cell row R2. More specifically, the first pass gate PG1 of the first half cell 110a and the second inverter PD2/PU2 of the second half cell 110b' are arranged along a same gate track. Correspondingly, the first inverter PD1/PU1 of the first half cell 110a and the second pass gate PG2 of the second half cell 110b' are arranged along a same gate track.

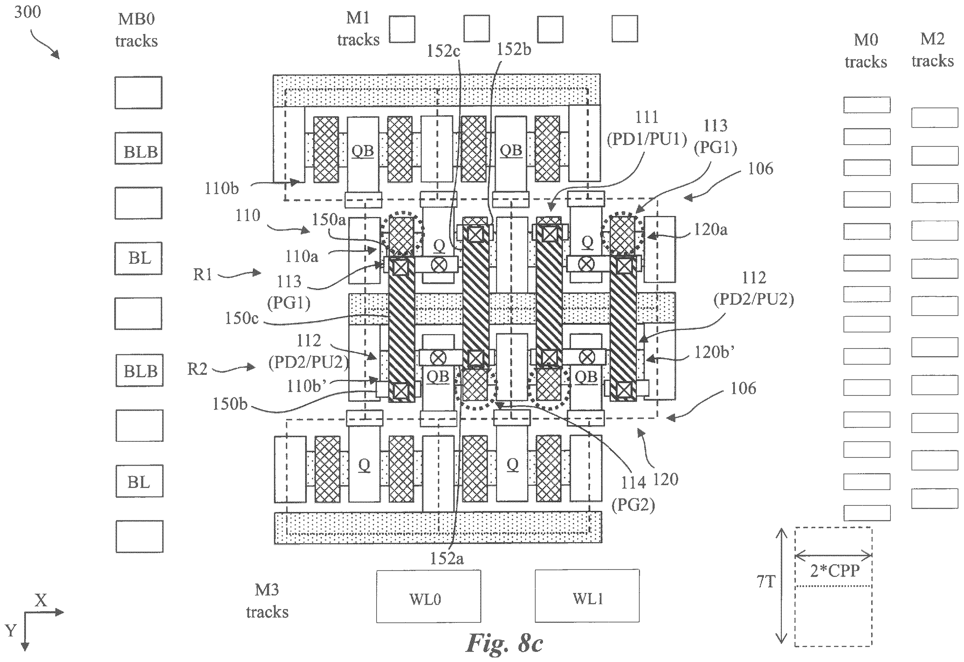

The cross coupling may as shown in Fig. 8c be realized using interconnects 150a-c and 152a-c in the M1 and M0 layers and vias of the V1 and V0 via layers, like in the SRAM device 200.

As each cell row R1, R2 only comprises first or second pass gates PG1, PG2, only a bit line BL or bit line bar BLB needs to be provided along each cell row R1, R2. As shown in Fig. 8c, the bit line BL and bit line bar BLB may be arranged in a pair of MB0 tracks.

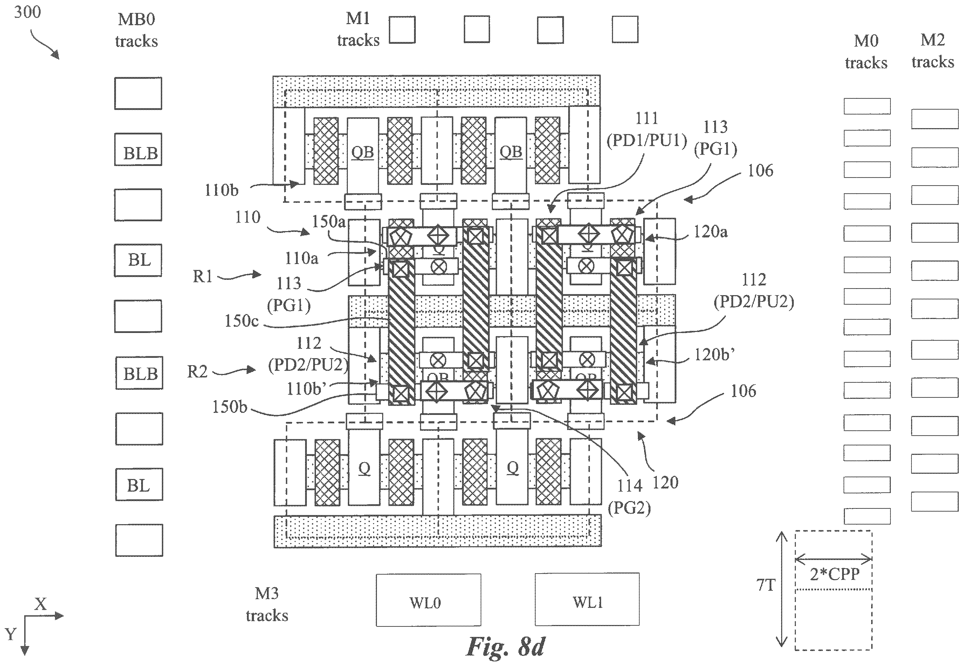

Due to the sharing of gate tracks between, on the one hand, the first pass gate PG1 and the second inverter PD2/PU2 of the bit cell 110, and on the other hand, the first inverter PD1/PU1 and the second pass gate PG2 of the bit cell 110, the M1 tracks of the third cross-couple portions of the cross-couple interconnects of the bit cell 110 may overlap the shared gate tracks. Arranging an intermediate M1 interconnect along these M1 tracks for the word line connections could hence require a tight tip-to-tip separation towards the third cross-couple portions, see encircled areas in Fig. 8c. To avoid this, a respective multi-level via (crossed pentagon) extending between the M2 and M0 layers as shown in Fig. 8d has been arranged, to realize the word line connections. The multi-level vias may thus bypass the M1 level and hence obviate the need for an intermediate M1 interconnect in the word line connections. The lines in the M2 layer may in turn be connected to the respective WLs (e.g., WL0 and WL1) of the M3 layer by vias of the V3 via layer (crossed diamond), as shown in Fig. 8d. To not overly obscure the figure, outlines for the WLs WL0 WL1 lines over the bit cell area have in Fig. 8d been omitted. However, if the tip-to-tip separations (i.e., at a sufficient via enclosure) are within the capabilities of the fabrication process used to form the M1 layer, it is also possible to realize the word line connections without multi-level vias, using interconnects in the M2, M1 and M0 layers and vias of the V3, V2, V1 and V0 via layers, like in the SRAM device 200.

Fig. 9a-c schematically shows the SRAM device 400 according to the fourth example implementation. The SRAM device 400 is an example of an implementation wherein instead of interconnecting the bottom and top S/D contact portions of the shared S/D contact structures by interconnect segments 106, the interconnection is provided by an intermediate S/D merge contact layer. As mentioned above, the S/D merge contact layer is not visible in the top down views of Fig. 9a-c, but corresponds to the S/D contact merge layer 22 as shown in Fig. 5.

Absent a row of interconnect segments, the spacer tracks in the SRAM device 400 instead accommodate an insulating wall structure 206 arranged in the bottom and top transistor tiers and extending continuously along each spacer track as an insulating and physical partition between the cell rows R1, R2.

In the SRAM device 400, like in the SRAM device 100, the first and second half cells 1 10a-b, 120a-b of each bit cell 110, 120 are comprised in a same cell row R1 or R2. Accordingly, the first and second cell rows R1, R2 of each double-row configuration are first and second rows of bit cells, such that each cell row R1, R2 comprises both first half cells 110a, 120a and second half cells 110b, 120b.

However, unlike the SRAM devices 100, 200, 300, the cell rows R1, R2 are not staggered. Rather the cell rows R1, R2 are aligned such that each shared S/D contact structure 232, 234 associated with the half cells 1 10a-b of the first cell row R1 is arranged directly opposite to a shared S/D contact structure 232, 234 associated with the half cells 120a-b of the second cell row R2, as seen along the second direction Y.

As the first and second half cells 1 10a-b, 120a-b of each respective bit cell 110, 120 are comprised in a same cell row, the cross-couple interconnects of each bit cell 110, 120 may be implemented like in the SRAM device 100, as may be seen in Fig. 9b. Reference is hence made to the above discussion of the cross-couple interconnects of the SRAM device 100.

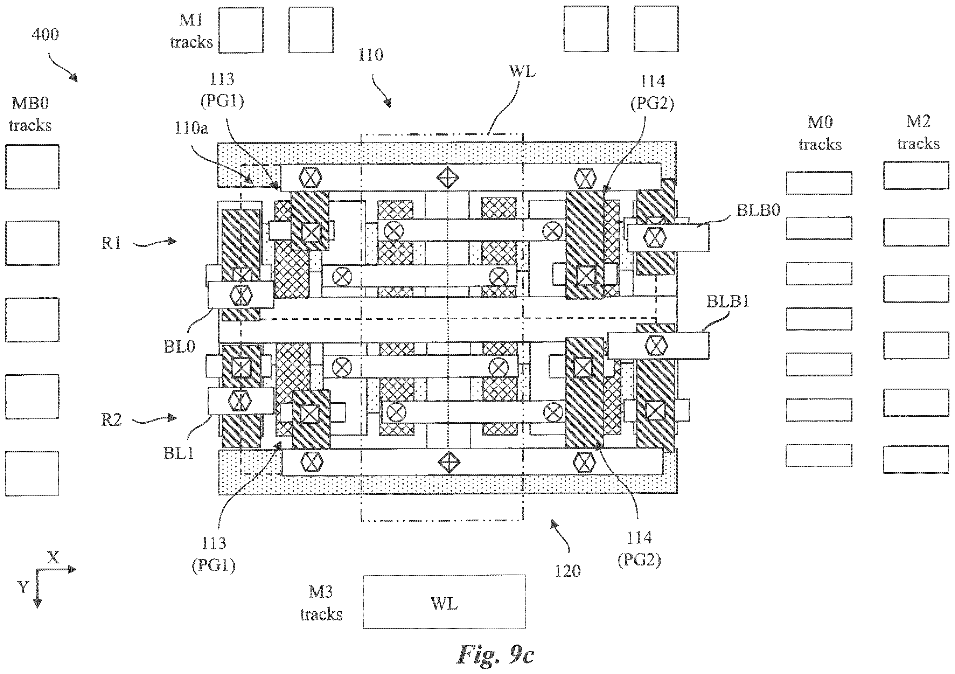

Also, the discussion of the bit line and bit line bar connections, and the word line connections in connection with the SRAM device 100 is in general applicable to the SRAM device 400. However, due to the non-staggered configuration of the cell rows R1, R2, the issue with staggered M1 routing tracks does not apply to the SRAM device 400. Hence, the first set of bit line and bit line bar BL0, BLB0 and the second set of bit line and bit line bar BL1, BLB1 may more easily be accommodated in the frontside interconnect structure, such as in respective M2 tracks as shown in Fig. 9c, without the associated potential issue of tip-to-tip shorting in the M0 layer.

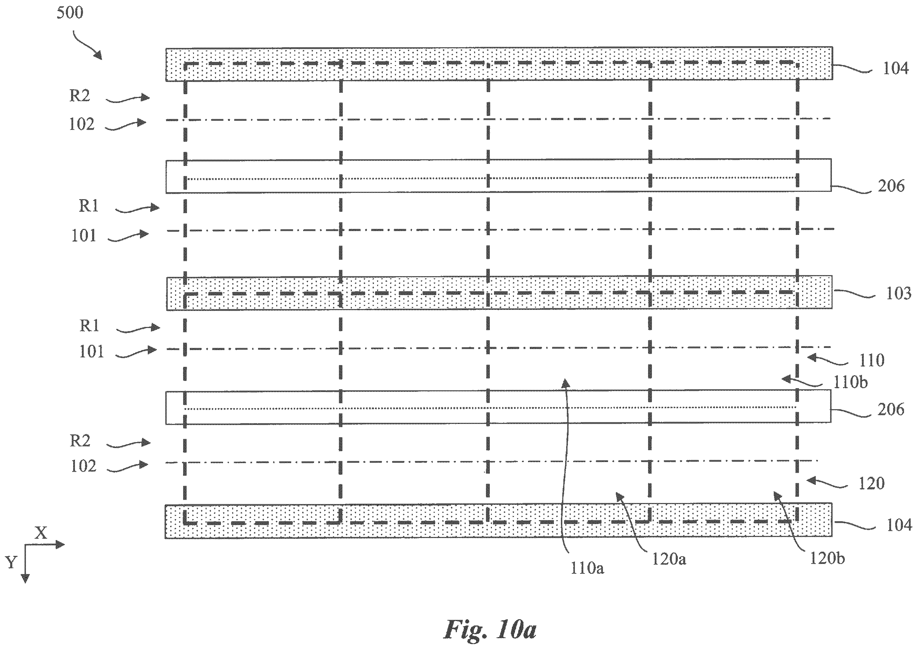

Fig. 10a-c schematically shows the SRAM device 500 according to the fifth example implementation. The SRAM device 500, like the SRAM device 400, uses S/D merge contact layers. However, in contrast to the SRAM device 400, the first and second half cells 1 10a-b, 120a-b of each bit cell 110, 120 are as shown comprised in different cell rows R1, R2. More specifically, the first cell row R1 comprises the first half cells 1 10a, 120a of a respective subset of bit cells (e.g., bit cells 110, 120) and the second cell row R2 comprises the second half cells 110b, 120b of the subset of bit cells (e.g., bit cells 110, 120). This is similar to the SRAM device 200, but different in that the cell rows R1, R2 are not staggered.

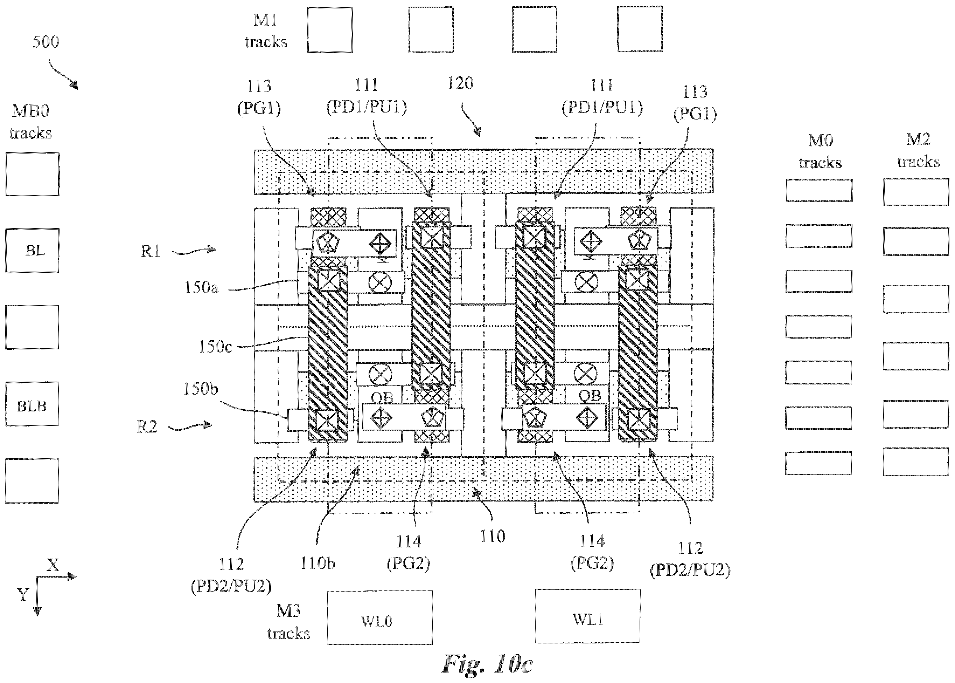

The cross-couple connections may as shown in Fig. 10c be realized using cross-couple interconnects in the M1 and M0 layers and vias of the V1 and V0 via layers, like in the SRAM device 300. The connections to the bit lines and bit line bars BL, BLB in the MB0 layer may be realized by VB0 vias, like in the SRAM device 300. The connections to the word lines WL in the M3 layer may as further shown in Fig. 10c be realized using interconnects in the M2 and M0 layers and vias of the V3 layer (crossed diamond) and V0 via layers (crossed circle), and multi-level vias (crossed pentagon) between the M2 and M0 layers, like in the SRAM device 300. Alternatively, the connections to the word lines WL may be realized using interconnects in the M2, M1 and M0 layers and vias of the V3, V2, V1 and V0 via layers, like in the SRAM device 100.

A number of example implementations of a pass gate device using a stacked transistor structure will now be discussed with reference to Fig. 11-13.

Fig. 11 schematically shows a first example of stacked transistor structures 30, 30' configured as respective pass gates PG1 (or PG2). Here, the pass gates PG1 are realized by the bottom devices 31, 31'. The top devices 32, 32' are configured as dummy devices as one of their S/D regions has been removed, e.g., by performing a cut through the S/D region (e.g., epitaxial body) during device fabrication.

Fig. 11 further shows, in a highly schematic manner, that the bottom S/D regions of the bottom devices 31, 31' may be coupled to a bit line BL in a backside interconnect layer by a backside via.

Fig. 12 schematically shows a second example of stacked transistor structures 40, 40' configured as respective pass gates PG1 (or PG2). Here, the pass gates PG1 are realized by the top devices 42, 42'. The bottom devices 41, 41' are configured as dummy devices as one of their S/D regions has been removed, e.g., by performing a cut through the S/D region (e.g., epitaxial body) during device fabrication.

Fig. 12 further shows, in a highly schematic manner, that the top S/D regions of the top devices 41, 41' may be coupled to a bit line BL in a backside interconnect layer by a tall backside via (e.g., a high aspect ratio via).

Fig. 13 schematically shows a third example of stacked transistor structures 50, 50' configured as respective pass gates PG1 (or PG2). Here, the pass gates PG1 are also realized by the top devices 52, 52'. The bottom devices 51, 51' are configured as dummy devices as one of their S/D regions has been removed, e.g., by performing a cut through the S/D region (e.g., epitaxial body) during device fabrication.

Fig. 13 further shows, in a highly schematic manner, that the top S/D regions of the top devices 41, 41' may be coupled to a bit line BL in a frontside interconnect layer by a frontside via.

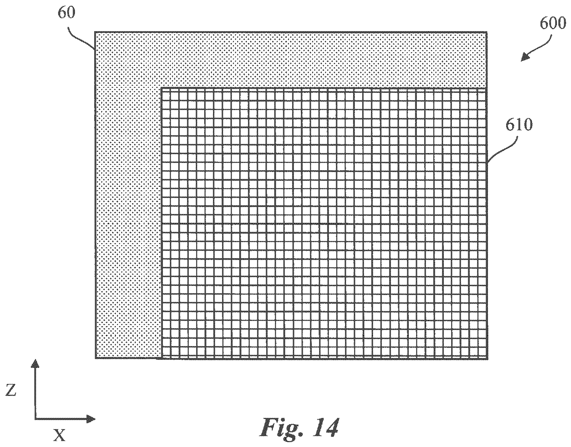

Fig. 14 schematically shows a block diagram of an SRAM device 600. The SRAM device 600 comprises an array of SRAM bit cells 610. The array 610 may be configured in accordance with either one of the SRAM devices 100, 200, 300, 400 or 500. The SRAM device 600 further comprises peripheral circuitry 60 arranged adjacent the SRAM array 610, i.e., in a periphery to the SRAM array 610. The peripheral circuitry 60 comprises a plurality of rows of circuit cells, such as standard cells (e.g., logic cells and/or I/O cells), and is configured to implement one or more of column and row decoder circuitry, write circuitry, read circuitry, etc.

The circuit cells of the peripheral circuitry 60 are like the bit cells of the array 610 based on the double-row configuration and thus matches a cell and track height of the cell rows of the array 610. The transistor and cell rows of the peripheral circuitry 60 may be implemented in accordance with any of configurations discussed with reference to Fig. 2-5. For instance, a shared signal routing structure may be arranged in spacer tracks between the pair of transistor and cell rows of one or more double-row configurations of the peripheral circuitry 60, and be configured to provide signal routing to and/or between bottom and top devices along the rows.

The person skilled in the art realizes that the present invention by no means is limited to the examples described above. On the contrary, many modifications and variations are possible within the scope of the appended claims. For example, while in the above, example implementations of SRAM devices have been disclosed with reference to figures showing SRAM bit cells with a width of 2CPP or 4CPP. However, it is also possible to implement SRAM bit cells with greater widths, e.g., by including one or more dummy gates and dummy gate tracks in the bit cells. For instance, introducing dummy gates may make it possible to provide rows of interconnect segments, corresponding to the rows 106, in the spacer tracks for interconnecting the bottom and top S/D contact portions of inverters without staggering the cell rows. Instead, dummy gates may be introduced to create a displacement between the shared S/D contact structures associated with the first and second cell rows.

## Claims

1. A static random access memory, SRAM, device (100, 200, 300, 400, 500) comprising:
a plurality of rows of transistor structures (101, 102) extending in parallel in a first direction (X) and spaced apart in a second direction (Y) transverse to the first direction, wherein the first direction corresponds to a channel direction of the transistor structures and wherein each row comprises bottom transistor structures (11) of a bottom transistor tier (10B) and top transistor structures (12) of a top transistor tier (10T), wherein the bottom transistor structures and the top transistor structures are of complementary conductivity types;
a plurality of SRAM bit cells (110, 120), each comprising a first and second half cell (110a-b, 120a-b),
wherein the half cells of the plurality of bit cells are arranged in a plurality of cell rows, each cell row comprising a respective row of transistor structures (101, 102),
wherein each first half cell (110a, 120a) comprises a first inverter (PD1/PU1), and a first pass gate (PG1) coupled between the first inverter and a bit line (BL), and each second half cell (110b, 120b) comprises a second inverter (PD2/PU2) cross-coupled with the first inverter, and a second pass gate (PG2) coupled between the second inverter and a bit line bar (BLB), and
wherein the first inverter comprises a first stacked transistor structure (111) comprising a first bottom and first top transistor structure having a first shared gate, the second inverter comprises a second stacked transistor structure (112) comprising a second bottom and second top transistor structure having a second shared gate, the first pass gate comprises a third bottom or top transistor structure (113), and the second pass gate comprises a fourth bottom or top transistor structure (114); and
a plurality of power rail structures (103, 104) extending in parallel in the first direction, wherein the power rail structures are interleaved with the rows of transistor structures such that a respective pair of neighboring first and second cell rows (R1, R2) comprising a respective pair of neighboring first and second rows of transistor structures (101, 102) is arranged between each pair of consecutive power rail structures,
wherein each power rail structure (103, 104) comprises a bottom power rail (1031, 1041) and a top power rail (1032, 1042) stacked over the bottom power rail, and
wherein the bottom and top transistor structures of each inverter are respectively coupled to the bottom and top power rails of the neighboring power rail structure.

2. The SRAM device according to claim 1, wherein the bottom power rails (1031, 1041) are arranged in the bottom transistor tier (10B) or in a backside interconnect layer (MB0), and/or wherein the top power rails (1032, 1042) are arranged in the top transistor tier (10T).

3. The SRAM device according to any one of the preceding claims, further comprising a bottom frontside interconnect layer (M0) of a frontside interconnect structure arranged on top of the top transistor tier and comprising a plurality of bottom frontside routing tracks extending in parallel in the first direction, and wherein a pitch of the power rail structures (103, 104) corresponds to 7 times a pitch of the bottom routing tracks.

4. The SRAM device according to any one of the preceding claims, wherein each half cell has a width along the first direction corresponding to 2 times a contacted poly pitch, CPP, of the transistor structures of the half cells.

5. The SRAM device according to any one of the preceding claims,
wherein a first source/drain, S/D, region of the third bottom or top transistor structure (113) of the first pass gate (PG1) and first bottom and top S/D regions of the first stacked transistor structure (111) of the first inverter (PD1/PU1) of each first half cell (1 10a, 120a) are interconnected by a first shared S/D contact structure (132, 232) arranged between the first and third transistor structures (111, 113) of the respective half cell, and
wherein a first S/D region of the fourth bottom or top transistor structure (114) of the second pass gate (PG2) and first bottom and top S/D regions of the second stacked transistor structure (112) of the second inverter (PD2/PU2) of each second half cell (110b, 120b) are interconnected by a second shared S/D contact structure (134, 234) arranged between the second and fourth transistor structures (112, 114) of the respective half cell.

6. The SRAM device (100, 200, 300) according to claim 5, further comprising a plurality of rows of interconnect segments (106) extending in parallel in the first direction, wherein each row of interconnect segments (106) extends along a shared boundary between a respective pair of neighboring first and second cell rows (R1, R2),
wherein each shared S/D contact structure (132, 134) comprises a bottom S/D contact portion (14), a top S/D contact portion (16), and a respective one of the interconnect segments (106), and
wherein the bottom and top S/D contact portions are vertically spaced apart from each other, and wherein the interconnect segment is arranged laterally adjacent to and in abutment with the bottom and top S/D contact portions to interconnect the same.

7. The SRAM device according to claim 6, when dependent on claim 4,
wherein in each pair of neighboring first and second cell rows (R1, R2), the second cell row (R2) is displaced relative the first cell row (R1) along the first direction (X) by a distance corresponding to one CPP such that the shared S/D contact structures (132, 134) associated with the half cells (1 10a, 1 10b) of the first cell row (R1) are displaced relative the shared S/D contact structures (132, 134) associated with the half cells (120a, 120b) of the second cell (R2) row by a corresponding distance, and
wherein every first interconnect segment (106a) of each respective row of interconnect segments (106) is comprised in a respective shared S/D contact structure (132, 134) associated with a half cell (1 10a, 1 10b) of the first cell row (R1) and every second interconnect segment (106b) of the row of interconnect segments (106) is comprised in a respective shared S/D contact structure (132, 134) associated with a half cell (120a, 120b) of the second cell row (R2).

8. The SRAM device (100) according to claim 7, wherein the first and second half cell (110a-b, 120a-b) of each respective bit cell are comprised in a same cell row (R1, R2) such that each first cell row (R1) comprises the first and second half cells (1 10a-b) of a respective first subset of bit cells (110) and each second cell row (R2) comprises the first and second half cells (120a-b) of a respective second subset of bit cells (120), and
the SRAM device further comprising:
a set of first bit lines and bit line bars (BL0, BLB0) and a set of second bit lines and bit line bars (BL 1, BLB1) arranged in a backside interconnect layer in a set of backside routing tracks (MB0) extending in parallel in the first direction, wherein each first bit line and bit line bar are arranged below a respective first cell row and coupled to the first and second pass gates thereof, and wherein each second bit line and bit line bar are arranged below a respective second cell row and coupled to the first and second pass gates thereof;
a set of cross-couple interconnects, wherein each cross-couple interconnect is configured to couple a storage node (Q, QB) of a half cell (110, 1 10b) of a respective bit cell (110) to the shared gate (141, 142) of the inverter (PD1/PU1, PD2/PU2) of the other half cell of the bit cell, and wherein each cross-couple interconnect comprises a cross-couple portion (150, 152) arranged in a bottom frontside interconnect layer (M0) in a routing track of a set of bottom frontside routing tracks extending in parallel in the first direction; and
a set of word lines (WL) arranged in an upper frontside interconnect layer in a set of upper frontside routing tracks (M3) extending in parallel in the second direction, wherein each word line is arranged over a respective column of the bit cells, and wherein the pass gates of each column of bit cells is coupled to the respective word line arranged over the column of the bit cells.

9. The SRAM device (200, 300) according to claim 7, wherein the first and second half cell (1 10a-b, 120a-b) of each respective bit cell (110, 120) are comprised in different neighboring cell rows (R1, R2), and
the SRAM device further comprising:
a set of bit lines and bit line bars (BL, BLB) arranged in a backside interconnect layer (MB0) in a set of backside routing tracks extending in parallel in the first direction, wherein each bit line (BL) is arranged below a respective first cell row (R1) and coupled to the first pass gates thereof (PG1), and wherein each bit line bar (BLB) is arranged below a respective second cell row (R2) and coupled to the second pass gates thereof (PG2);
a set of cross-couple interconnects, wherein each cross-couple interconnect is configured to couple a storage node (Q) of a half cell (1 10a) of a respective bit cell (110) to the shared gate (142) of the inverter (PD2/PU2) of the other half cell (1 10b) of the bit cell (110), and wherein each cross-couple interconnect comprises a first and second cross-couple portion (150a, 150b) arranged in a bottom frontside interconnect layer (M0) in respective routing tracks of a set of bottom frontside routing tracks extending in parallel in the first direction (X), and a third cross-couple portion (150c) arranged in an intermediate frontside interconnect layer (M1) in a routing track of a set of intermediate frontside routing tracks extending in parallel in the second direction (Y); and
a set of word lines (WL0, WL1) arranged in an upper frontside interconnect layer (M3) in a set of upper frontside routing tracks extending in parallel in the second direction (Y), wherein each word line (WL0) is arranged over a respective column of the bit cells (110), and wherein the pass gates of each column of bit cells (PG1, PG2) are coupled to the respective word line (WL0) arranged over the column of the bit cells.

10. The SRAM device according to claim 9,
wherein the first cell row (R1) of each respective pair of neighboring first and second cell rows comprises the first half cells (110a, 120a) of a respective subset of bit cells (110, 120) and the second cell row (R2) comprises the second half cells (1 10b, 120b) of the subset of bit cells (110, 120), or
wherein the first cell row (R1) of each respective pair of neighboring first and second cell rows comprises the first half cells (110a, 120a) of a respective first subset of bit cells (110, 120) and the second cell row (R2) comprises the second half cells (110b', 120b') of a respective second subset of bit cells (110', 120').

11. The SRAM device (400, 500) according to claim 5, wherein each first and second shared S/D contact structure (232, 234) comprises a S/D contact merge layer (22) arranged between and configured to interconnect a bottom S/D contact portion (15) and a top S/D contact portion (18) of the shared S/D contact structure.

12. The SRAM device according to claim 11, wherein the first and second cell rows (R1, R2) are aligned such that each shared S/D contact structure (232, 234) associated with a half cell (110a, 110b) of the first cell row (R1) is arranged directly opposite a respective shared S/D contact structure (232, 234) associated with a half cell (120a, 120b) of the second cell row (R2), as seen along the second direction (Y).

13. The SRAM device (400) according to any one of claims 11-12, wherein the first and second half cell (1 10a-b, 120a-b) of each respective bit cell are comprised in a same cell row (R1, R2),
the SRAM device further comprising:
a set of cross-couple interconnects, wherein each cross-couple interconnect is configured to couple a storage node (Q) of a half cell (1 10a) of a respective bit cell (110) to the shared gate of the inverter (142) of the other half cell (1 10b) of the bit cell (110), and wherein each cross-couple interconnect comprises a cross-couple portion (150) arranged in a bottom frontside interconnect layer (M0) in a routing track of a set of bottom frontside routing tracks extending in parallel in the first direction (X);
a set of word lines (WL) arranged in an upper frontside interconnect layer (M3) in a set of upper frontside routing tracks extending in parallel in the second direction (Y), wherein each word line (WL) is arranged over a respective column of the bit cells (110, 120), and wherein the pass gates of each column of bit cells (PG1, PG2) is coupled to the respective word line arranged over the column of the bit cells; and
a set of first bit lines and bit line bars (BL0, BLB0) and a set of second bit lines and bit line bars (BL 1, BLB1) arranged in a further interconnect layer in a set of further routing tracks extending in parallel in the first direction (X), wherein each first bit line and bit line bar (BL0, BLB0) are arranged along a respective first cell row (R1) and coupled to the first and second pass gates thereof (PG1, PG2), and wherein each second bit line and bit line bar (BL1, BLB1) are arranged along a respective second cell row (R2) and coupled to the first and second pass gates thereof (PG1, PG2),
wherein the further interconnect layer is a backside interconnect layer or an intermediate frontside interconnect layer (M2) arranged between the bottom and upper frontside interconnect layers (M0, M3).

14. The SRAM device (500) according to any one of claims 11-12, wherein the first and second half cell (1 10a-b, 120a-b) of each respective bit cell (110, 120) are comprised in different neighboring cell rows such that each first half cell (110a, 120a) is comprised in a first cell row (R1) and each second half cell (1 10b, 120b) is comprised in a second cell row (R2),
the SRAM device further comprising:
a set of bit lines and bit line bars (BL, BLB) arranged in a backside interconnect layer (MB0) in a set of backside routing tracks extending in parallel in the first direction (X), wherein each bit line (BL) is arranged below a respective first cell row (R1) and coupled to the first pass gates thereof (PG1), and wherein each bit line bar (BLB) is arranged below a respective second cell row (R2) and coupled to the second pass gates thereof (PG2);
a set of cross-couple interconnects, wherein each cross-couple interconnect is configured to couple a storage node (Q) of a half cell (1 10a) of a respective bit cell (110) to the shared gate of the inverter (142) of the other half cell (1 10b) of the bit cell (110), and wherein each cross-couple interconnect comprises a first and second cross-couple portion (150a, 150b) arranged in a bottom frontside interconnect layer (M0) in respective routing tracks of a set of bottom frontside routing tracks extending in parallel in the first direction (X), and a third cross-couple portion (150c) arranged in an intermediate frontside interconnect layer (M1) in a routing track of set of intermediate frontside routing tracks extending in parallel in the second direction (Y); and
a set of word lines (WL0, WL1) arranged in an upper frontside interconnect layer (M3) in a set of upper frontside routing tracks extending in parallel in the second direction (Y), wherein each word line (WL0, WL1) is arranged over a respective column of the bit cells (110, 120), and wherein the pass gates (PG1, PG2) of each column of bit cells is coupled to the respective word line (WL0, WL1) arranged over the column of the bit cells.

15. The SRAM device (600) according to any one of the preceding claims, further comprising peripheral circuitry (60) comprising a plurality of rows of logic circuit cells, each circuit cell comprising:
a pair of power rail structures extending in parallel in the first direction;
at least a first stacked transistor structure of a first row of transistor structures, and at least a second stacked transistor structure of a second row of transistor structures, wherein the first and second rows of transistor structures extend in parallel in the first direction and are arranged between the pair of power rail structures; and
a shared signal routing structure arranged between the first and second rows of transistor structures and electrically coupled to: a bottom transistor structure of the first stacked transistor structure, a top transistor structure of the first stacked transistor structure, a bottom transistor structure of the second stacked transistor structure, and/or a top transistor structure of the second stacked transistor structure.
